# EUROPEAN PATENT SPECIFICATION

(11) **EP 1 579 516 B1**
(45) Date of publication and mention of the grant of the patent: **28.03.2007**
(21) Application number: 03769112.8
(22) Date of filing: 15.10.2003
(51) Int. Cl.: H01L 51/50, H01L 51/30, G06N 3/12, G11C 13/02

(54) **CHEMICAL SWITCHING OF NUCLEIC ACID CIRCUIT ELEMENTS**
CHEMISCHE SCHALTUNG VON NUKLEINSÄURESCHALTUNGSELEMENTEN
PERMUTATION CHIMIQUE D'ELEMENTS DE CIRCUIT D'ACIDES NUCLEIQUES

(30) Priority: 23.12.2002 US 435276 P
(43) Date of publication of application: 28.09.2005
(73) Proprietor: University of Saskatchewan, Saskatoon, SK S7N 4J8 (CA)
(72) Inventor: LEE, Jeremy S., Univ. of Saskatchewan Tech. Inc., Saskatoon, Saskatchewan S7N 5C8 (CA); KRAATZ, Heinz-Bernhard, Saskatoon, Saskatchewan S7H 0Y9 (CA); WETTIG, Shawn D., Saskatoon, Saskatchewan S7S 1L5 (CA); SKINNER, Ryan John, Prince Albert, Saskatchewan S6V 0E7 (CA)
(74) Representative: Bassil, Nicholas Charles
(86) International application number: PCT/CA2003/001589
(87) International publication number: WO 2004/057685

(56) References cited:
- EP-A- 1 215 199
- WO-A-99/04440
- WO-A-02/095840

## Description

### 1. Field of Invention

The present invention relates to nucleic acids, and more particularly, to organic circuit elements and related methods.

### 2. Description of Related Art

The field of organic electronics has been given increased attention in an effort to create inexpensive circuit elements which operate on the molecular level to facilitate ever-increasing density requirements of producing smaller circuits. Today's silicon-based microelectronic devices have a minimum size between electrical components of about a tenth of a micron. But in molecular electronics, nanometer-sized components could yield chips exponentially more powerful than anything of a comparable size today or computing devices unimaginably tiny by contemporary standards. Moreover, the search for flexible circuits which are compatible with plastic substrates to produce digitized versions of newspapers, product labels and integrated circuits, for example, has led to the investigation of organic materials as electronic devices.

In this regard, biological materials such as DNA are of interest because of the potential for molecular recognition and the ability to synthesize them using biological machinery. Moreover, due to its importance in living organisms, DNA has been subjected to a wide range of structural, kinetic, and thermodynamic probes (Gelbart et al., **2000**). However, recently, measurements of electrical transport through individual short DNA molecules indicate wide-band gaps semiconductor behavior (Porath et al., **2000**), while other measurements of DNA hairpins have indicated that DNA is only somewhat more effective than proteins as a conductor of electrons (Lewis et al., **1997**; Taubes, **1997**). United States Patent Nos. **5,591,578; 5,705,348; 5,770,369; 5,780,234** and **5,824,473** issued to Meade *et al.* on, respectively, **7** January **1997**, **6** January **1998, 23** June **1998, 14** July **1998** and **20** October **1998** (and incorporated herein by reference) disclose nucleic acids that are covalently modified with electron transfer moieties along the nucleic acid backbone. Meade et al. suggest that such modifications are necessary for nucleic acids to efficiently mediate electron transfer.

A new form of conductive nucleic acid has recently been found which is described in International Patent Publication WO **99/31115**, Aich et al., **1999**, and Rakitin et al., **2000**, all of which are incorporated herein by reference. M-DNA is a novel conformation of duplex DNA in which the imino protons of each base pair are replaced by a metal ion (such as Zn²⁺, Ni²⁺ or Co²⁺). It has been shown by two independent methods (Aich et al., **1999,** and Rakitin et al., **2000**) that M-DNA conducts electrons in contrast to normal duplex DNA, which is reportedly a semiconductor at best. Direct measurements of the conductivity of M-DNA were performed by stretching phage λ-DNA between two electrodes separated by **3** to **10** microns (Rakitin et al., **2000**). Indirect measurements of the conductivity were estimated from fluorescent lifetime measurements of duplexes with a donor fluorophore at one end and an acceptor fluorophore at the other (Rakitin et al., **2000,** Aich et al., **1999**). Upon conversion to M-DNA, the fluorescein of the donor was quenched and the lifetime was so short as to be only consistent with an electron transfer mechanism. The transfer of electrons from excited fluorophores indicates that M-DNA may for example be used in some embodiments as a molecular wire.

WO 02/095840 relates to organic circuit elements that include a plurality of oligonucleotide duplex members and a method of regulating an electronic signal between first and second locations in the conductive nucleic acid material.

WO 99/04440 relates to a microelectronic network fabricated on a fibrous skeleton by binding or complexing electronically functional substances to the nucleic acid skeleton. The skeleton comprises fibers with nucleotide chains.

EP-A-12I5199 relates to linker molecules comprising one or more nucleic acid binding groups, and one or more nanoparticle binding groups, which are connected covalently by a spacer group. The invention provides methods for the controlled and selective metallisation of nucleic acids, and the production of nanowires.

### SUMMARY OF THE INVENTION

An organic circuit element includes a plurality of members, each of which includes an oligonucleotide duplex. The plurality of members includes at least one donor member for receiving conduction electrons from an electron donor, at least one acceptor member for communicating with an electron acceptor to provide a region of attraction for the conduction electrons, and at least one regulator member intersecting with at least one of the plurality of members to define at least one electric field regulation junction, for cooperating with an electric field regulator to regulate an electric field at the junction.

At least some of the plurality of members may include a conductive metal-containing oligonucleotide duplex. For example, each of the members may include such a conductive metal-containing oligonucleotide duplex. Alternatively, the at least one donor member and the at least one acceptor member may include such a conductive metal-containing oligonucleotide duplex.

The organic circuit element may further include the electron donor in electrical communication with the donor member. Similarly, the organic circuit element may include the electron acceptor in electrical communication with the acceptor member. Alternatively, or in addition, the organic circuit element may include the electric field regulator in electrical communication with the regulator member.

The donor member, the acceptor member and the regulator member may intersect to define the electric field regulation junction.

Alternatively, the regulator member may intersect with one of the donor member and the acceptor member to define the electric field regulation junction.

Alternatively, the plurality of members may include a common member, and the donor member, the acceptor member and the regulator member may intersect the common member at first, second and third locations respectively, the third location defining the electric field regulation junction.

The at least one regulator member may include a plurality of regulator members, the plurality of regulator members intersecting other respective members of the plurality of members to define the at least one electric field regulation junction.

The conductive metal-containing oligonucleotide duplex may include a first nucleic acid strand and a second nucleic acid strand, the first and second nucleic acid strands including respective pluralities of nitrogen-containing aromatic bases covalently linked by a backbone. The nitrogen-containing aromatic bases of the first nucleic acid strand may be joined by hydrogen bonding to the nitrogen-containing aromatic bases of the second nucleic acid strand. The nitrogen-containing aromatic bases on the first and the second nucleic acid strands may form hydrogen-bonded base pairs in stacked arrangement along a length of the conductive metal-containing oligonucleotide duplex. The hydrogen-bonded base pairs may include an interchelated metal cation coordinated to a nitrogen atom in one of the nitrogen-containing aromatic bases.

The interchelated metal cation may include an interchelated divalent metal cation.

The divalent metal cation may be selected from the group consisting of zinc, cobalt and nickel.

Alternatively, the metal cation may be selected from the group consisting of the cations of Li, Be, Na, Mg, Al, K, Ca, Sc, Ti, V, Cr, Mn, Fe, Co, Ni, Cu, Zn, Ga, Ge, As, Rb, Sr, Y, Zr, Nb, Mo, Tc, Ru, Rh, Pd, Ag, Cd, In, Sn, Sb, Cs, Ba, La, Ce, Pr, Nd, Pm, Sm, Eu, Gd, Tb, Dy, Ho, Er, Tm, Yb, Lu, Hf, Ta, W, Re, Os, Ir, Pt, Au, Hg, TI, Pb, Bi, Po, Fr, Ra, Ac, Th, Pa, U, Np and Pu.

The first and the second nucleic acid strands may include deoxyribonucleic acid and the nitrogen-containing aromatic bases may be selected from the group consisting of adenine, thymine, guanine and cytosine.

The divalent metal cations may be substituted for imine protons of the nitrogen-containing aromatic bases, and the nitrogen-containing aromatic bases may be selected from the group consisting of thymine and guanine.

If desired, at least one of the nitrogen-containing aromatic bases may include thymine, having an N3 nitrogen atom, and the divalent metal cation may be coordinated by the N3 nitrogen atom.

Alternatively, if desired, at least one of the nitrogen-containing aromatic bases may include guanine, having an N1 nitrogen atom, and the divalent metal cation may be coordinated by the N1 nitrogen atom.

The electron donor may include an electrode operable to donate an electron to the donor member.

Alternatively, or in addition, the electron donor may include an electron donor molecule capable of donating an electron to the donor member. The electron donor molecule may include a fluorescent molecule, such as fluorescein, for example.

The electron acceptor may include an electrode operable to accept an electron from the acceptor member.

Alternatively, or in addition, the electron acceptor may include an electron acceptor molecule capable of accepting an electron from the acceptor member. The electron acceptor molecule may include a fluorescent molecule, such as rhodamine, for example.

The electric field regulator may include a regulator chromophore. The regulator chromophore may absorb radiation within a range of wavelengths.

The electric field regulator may include a fluorescent molecule, such as fluorescein or rhodamine, for example.

The electron acceptor may include a chromophore operable to emit radiation within a range of wavelengths in response to accepting an electron from the acceptor member.

In some embodiments, the electron donor or acceptor moieties may be chemically altered to change the electrical properties of the nucleic acid circuit element. The donors or acceptors may for example be reversibly reduced or oxidized under conditions that preserve the potential for conductivity of the M-DNA.

The electric field regulator may include an electrode, which may be operable to perform at least one of accepting an electron from the acceptor member and donating an electron to the donor member.

The electric field regulator may include a plurality of states, each state of the plurality of states being selectable to produce a respective electrostatic potential at the electric field regulation junction. The states may be selectable in response to an applied external potential, or by irradiating the electric field regulator, for example.

A system including an organic circuit element as described above, can further include a conductive medium for supplying conduction electrons to the electron donor and for receiving conduction electrons from the electron acceptor.

The conductive medium may be operable to donate electrons to the electron donor, and may be operable to accept electrons from the electron acceptor to provide a closed circuitway for electrons to flow from the electron donor, through the donor member, through the electric field regulation junction, through the acceptor member, through the electron acceptor, and back to the electron donor.

The conductive medium may include an aqueous solution. Or, the conductive medium may include a conductive wire.

The method of making such an element includes annealing and treating a plurality of oligonucleotides to form a plurality of members, each member of the plurality of members including a pair of the oligonucleotides aligned to form a duplex portion. The plurality of members includes at least one donor member for receiving conduction electrons from an electron donor, at least one acceptor member for communicating with an electron acceptor to provide a region of attraction for the conduction electrons, and at least one regulator member intersecting with at least one of the plurality of members to define at least one electric field regulation junction, for cooperating with an electric field regulator to regulate an electric field at the junction.

The method may further include placing the electron donor in electrical communication with the donor member. Similarly, the method may include placing the electron acceptor in electrical communication with the acceptor member. Additionally, or alternatively, the method may include placing the electric field regulator in electrical communication with the regulator member.

Annealing and treating may include annealing and treating the plurality of oligonucleotides to form the plurality of members in a configuration in which the donor member, the acceptor member and the regulator member intersect to define the electric field regulation junction.

Alternatively, annealing and treating may include annealing and treating the plurality of oligonucleotides to form the plurality of members in a configuration in which the regulator member intersects with one of the donor member and the acceptor member to define the electric field regulation junction.

Alternatively, the plurality of members may include a common member, and wherein annealing and treating include annealing and treating the plurality of oligonucleotides to form the plurality of members in a configuration in which the donor member, the acceptor member and the regulator member intersect the common member at first, second and third locations respectively, the third location defining the electric field regulation junction.

The plurality of members may include a plurality of regulator members, in which case annealing and treating may include annealing and treating the plurality of oligonucleotides to form the members in a configuration in which the plurality of regulator members intersect the plurality of members to define the at least one electric field regulation junction.

Annealing may include annealing the plurality of oligonucleotides in conditions effective to form the duplex portion, and treating may include treating the plurality of oligonucleotides in conditions effective to form the at least one electric field regulation junction.

The oligonucleotides may include a plurality of nitrogen-containing aromatic bases covalently linked by a backbone.

The oligonucleotides may include a deoxyribonucleic acid including nitrogen-containing aromatic bases selected from the group consisting of adenine, thymine, guanine, cytosine, and uracil.

The duplex portion may include a conductive metal-containing oligonucleotide duplex portion, the conductive metal-containing oligonucleotide duplex portion including a first strand and a second strand of the oligonucleotides, the nitrogen-containing aromatic bases of the first strand joined by hydrogen bonding to the nitrogen-containing aromatic bases of the second strand, the nitrogen-containing aromatic bases on the first and second strands forming hydrogen-bonded base pairs in stacked arrangement along a length of the conductive metal-containing oligonucleotide duplex portion, the hydrogen-bonded base pairs including an interchelated metal cation coordinated to a nitrogen atom in one of the nitrogen-containing aromatic bases.

The interchelated metal cation may include an interchelated divalent metal cation.

Annealing may include subjecting the plurality of oligonucleotides to a basic solution under conditions effective to form the conductive metal-containing oligonucleotide duplex portion.

The conditions effective to form the conductive metal-containing oligonucleotide duplex portion may include conditions effective to substitute the divalent metal cations for an imine proton of a nitrogen containing aromatic base in the conductive metal-containing oligonucleotide duplex portion.

The basic solution may have a pH of at least 7, and may have a nucleic acid to metal ion ratio of about 1:1.5 to about 1:2.0, for example.

The divalent metal cation may be selected from the group consisting of zinc, cobalt and nickel.

Alternatively, the metal cation may be selected from the group consisting of the cations of Li, Be, Na, Mg, Al, K, Ca, Sc, Ti, V, Cr, Mn, Fe, Co, Ni, Cu, Zn, Ga, Ge, As, Rb, Sr, Y, Zr, Nb, Mo, Tc, Ru, Rh, Pd, Ag, Cd, In, Sn, Sb, Cs, Ba, La, Ce, Pr, Nd, Pm, Sm, Eu, Gd, Tb, Dy, Ho, Er, Tm, Yb, Lu, Hf, Ta, W, Re, Os, Ir, Pt, Au, Hg, TI, Pb, Bi, Po, Fr, Ra, Ac, Th, Pa, U, Np and Pu. For example, in some embodiments, varying amounts of metal cations may be incorporated into a duplex, such as Zn²⁺, Ni²⁺, Co²⁺, Cd²⁺ , Hg²⁺, Pt²⁺ and Ag¹⁺, where metal ions such as Cd²⁺, Hg²⁺, Pt²⁺ and Ag¹⁺ may constitute only a portion of the metal ions in the duplex, in effect 'doping' the duplex.

The divalent metal cations may be substituted for imine protons of the nitrogen-containing aromatic bases, and the nitrogen-containing aromatic bases may be selected from the group consisting of thymine and guanine.

If desired, at least one of the nitrogen-containing aromatic bases may include thymine, having an N3 nitrogen atom, and the divalent metal cation may be coordinated by the N3 nitrogen atom.

Similarly, at least one of the nitrogen-containing aromatic bases may include guanine, having an N1 nitrogen atom, and the divalent metal cation may be coordinated by the N1 nitrogen atom.

The electron donor may include an electron donor molecule capable of donating an electron to the donor member. Similarly, the electron acceptor may include an electron acceptor molecule capable of accepting an electron from the acceptor member.

The electron donor molecule may include a fluorescent molecule, such as fluorescein, for example.

Similarly, the electron acceptor molecule may include a fluorescent molecule, such as rhodamine, for example.

Alternatively, the electron donor may include an electrode operable to donate an electron to the donor member.

Similarly, the electron acceptor may include an electrode operable to accept an electron from the acceptor member.

The electric field regulator may include a fluorescent molecule, such as fluorescein or rhodamine, for example.

The electric field regulator may include a regulator chromophore. If so, the regulator chromophore may absorb radiation within a range of wavelengths.

The electron acceptor may include a chromophore operable to emit radiation within a range of wavelengths in response to accepting an electron from the acceptor member.

Treating may include subjecting the plurality of oligonucleotides to a basic solution under conditions effective to form the electric field regulation junction.

The electric field regulator may include an electrode, which may be operable to perform at least one of accepting an electron from the acceptor member and donating an electron to the donor member.

The electric field regulator may include a plurality of states, each state of the plurality of states being selectable to produce a respective electrostatic potential at the electric field regulation junction.

In accordance with the invention as defined in the appended claim, there is provided a method of regulating an electronic signal between first and second locations in a conductive nucleic acid material. The method includes varying an electrostatic potential at a third location in the nucleic acid material interposed between the first and second locations.

Varying may include selecting one of a plurality of states of an electric field regulator in communication with the third location, each of the states corresponding to a respective electrostatic potential at the third location.

Selecting may include irradiating the electric field regulator. For example, if the electric field regulator includes a chromophore, or is selected from the group consisting of fluorescent molecules and chromophores, selecting may include irradiating the electric field regulator.

Irradiating may include irradiating the chromophore to cause a negative electrostatic potential to be applied to the third location.

Alternatively, selecting may include applying an external potential to the electric field regulator. For example, if the electric field regulator includes an electrode, and selecting may include applying an external potential to the electrode.

Applying may include depositing at least one electron onto the electrode to apply a negative electrostatic potential to the third location.

Conversely, applying may include removing at least one electron from the electrode to apply a positive electrostatic potential to the third location.

The method may further include producing the electronic signal. This may include causing electrons to flow from the first location to the second location, and may further include supplying electrons to the first location and receiving electrons from the second location, for example.

The first location may include a location in a conductive nucleic acid electron donor member, the second location may include a location in a conductive nucleic acid electron acceptor member, and the third location may include at least one electric field regulation junction in electrical communication with the donor member and the acceptor member. If so, then varying may include varying the electrostatic potential at the at least one electric field regulation junction.

The at least one electric field regulation junction may be in electrical communication with a conductive nucleic acid electric field regulator member. In such a case, varying may include selecting one of a plurality of states of an electric field regulator in electrical communication with the regulator member, each of the states corresponding to a respective electrostatic potential at the at least one electric field regulation junction.

As noted above, selecting may include irradiating the electric field regulator, for example, where the regulator is selected from the group consisting of fluorescent molecules and chromophores, or is a chromophore. In the latter case, irradiating may include irradiating the chromophore to cause a negative electrostatic potential to be applied to the electric field regulation junction, the negative electrostatic potential decreasing the ability of an electron to travel from the donor member to the acceptor member.

Alternatively, selecting may include applying an external potential to the electric field regulator, for example, where the regulator includes an electrode. In the latter case, applying may include depositing at least one electron onto the electrode to apply a negative electrostatic potential to the electric field regulation junction, the negative electrostatic potential decreasing the ability of an electron to travel from the donor member to the acceptor member. Conversely, applying may include removing at least one electron from the electrode to apply a positive electrostatic potential to the electric field regulation junction, the positive electrostatic potential increasing the ability of an electron to travel from the donor member to the acceptor member.

The method may further include placing the electron donor member, the electron acceptor member, and the regulator member in electrical communication with an electron donor, an electron acceptor, and the electric field regulator, respectively.

The method may further include producing the electronic signal. Producing may include causing electrons to flow from an electron donor in communication with the electron donor member, to an electron acceptor in communication with the electron acceptor member. The method may further include supplying electrons to the electron donor and receiving electrons from the electron acceptor.

The at least one electric field regulation junction may include at least two electric field regulation junctions in electrical communication with at least two respective electric field regulators. If so, then wherein varying may include selecting one of a plurality of states of at least one of the at least two electric field regulators, each of the states corresponding to a respective electrostatic potential at the electric field regulation junction corresponding to the at least one of the at least two electric field regulators.

The conductive nucleic acid material may include a plurality of members, each of which may include a conductive metal-containing oligonucleotide duplex. The plurality of members may include at least one donor member for receiving conduction electrons from an electron donor, at least one acceptor member for communicating with an electron acceptor to provide a region of attraction for the conduction electrons, and at least one regulator member intersecting with at least one of the plurality of members to define at least one electric field regulation junction, for cooperating with an electric field regulator to regulate an electric field at the junction. In such a case, varying may include selecting one of a plurality of states of the electric field regulator, each of the states corresponding to a respective electrostatic potential at the electric field regulation junction.

The conductive nucleic acid material may include a conductive metal-containing nucleic acid duplex. The duplex may include a regulator member in electrical communication with an electric field regulator, a donor member in electrical communication with an electron donor, and an acceptor member in electrical communication with an electron acceptor. In such a case, varying may include changing the state of the electric field regulator to vary an electrostatic potential at an electric field regulation junction joining the regulator member, the donor member, and the acceptor member, to regulate the signal.

The conductive metal-containing nucleic acid duplex may include a nucleic acid duplex including a first nucleic acid strand and a second nucleic acid strand. The first and the second nucleic acid strands may include respective pluralities of nitrogen-containing aromatic bases covalently linked by a backbone. The nitrogen-containing aromatic bases of the first nucleic acid strand may be joined by hydrogen bonding to the nitrogen-containing aromatic bases of the second nucleic acid strand. The nitrogen-containing aromatic bases on the first and the second nucleic acid strands may form hydrogen-bonded base pairs in stacked arrangement along a length of the nucleic acid duplex.

The method may further include producing the conductive metal-containing nucleic acid duplex. Producing may include subjecting the nucleic acid duplex to a basic solution in the presence of a metal cation under conditions effective to form the conductive metal-containing nucleic acid duplex, wherein the hydrogen-bonded base pairs of the conductive metal-containing nucleic acid duplex include an interchelated metal cation coordinated to a nitrogen atom in one of the nitrogen-containing aromatic bases.

More particularly, producing may include subjecting the nucleic acid duplex to a basic solution in the presence of a divalent metal cation under conditions effective to form the conductive metal-containing nucleic acid duplex, wherein the hydrogen-bonded base pairs of the conductive metal-containing nucleic acid duplex include an interchelated divalent metal cation coordinated to a nitrogen atom in one of the nitrogen-containing aromatic bases.

The nucleic acid duplex may include a deoxyribonucleic acid duplex including nitrogen-containing aromatic bases selected from the group consisting of adenine, thymine, guanine and cytosine.

The conditions effective to form the conductive metal-containing nucleic acid duplex may be effective to substitute the divalent metal cations for an imine proton of a nitrogen containing aromatic base in the nucleic acid duplex.

The divalent metal cation may be selected from the group consisting of zinc, cobalt and nickel. Alternatively, the metal cation may be selected from the group consisting of the cations of Li, Be, Na, Mg, Al, K, Ca, Sc, Ti, V, Cr, Mn, Fe,

Co, Ni, Cu, Zn, Ga, Ge, As, Rb, Sr, Y, Zr, Nb, Mo, Tc, Ru, Rh, Pd, Ag, Cd, In, Sn, Sb, Cs, Ba, La, Ce, Pr, Nd, Pm, Sm, Eu, Gd, Tb, Dy, Ho, Er, Tm, Yb, Lu, Hf, Ta, W, Re, Os, Ir, Pt, Au, Hg, TI, Pb, Bi, Po, Fr, Ra, Ac, Th, Pa, U, Np and Pu.

The basic solution may have a pH of at least 7, and may have a nucleic acid to metal ion ratio of about 1:1.5 to about 1:2.0, for example.

The electron donor may include an electron donor molecule capable of donating an electron to the donor member. The electron donor molecule may include a fluorescent molecule, such as fluorescein, for example.

Similarly, the electron acceptor may include an electron acceptor molecule capable of accepting an electron from the acceptor member. The electron acceptor molecule may include a fluorescent molecule, such as rhodamine, for example.

Alternatively, or in addition, the electron donor may include an electrode operable to donate an electron to the donor member. Similarly, the electron acceptor may include an electrode operable to accept an electron from the acceptor member.

The electric field regulator may include a regulator chromophore, or a fluorescein, or a rhodamine, for example. The regulator chromophore may absorb radiation within a range of wavelengths.

The electron acceptor may include a chromophore operable to emit radiation within a range of wavelengths in response to accepting an electron from the acceptor member. The radiation may irradiate a second chromophore in series.

Any or all of the regulator member, the donor member and the acceptor member may include a conductive metal-containing nucleic acid duplex portion.

The method may further include supplying conduction electrons from a conductive medium to the conductive metal-containing nucleic acid duplex, and receiving conduction electrons from the duplex at the conductive medium. Supplying may include donating electrons from the conductive medium to the electron donor, and receiving may include accepting electrons from the electron acceptor at the conductive medium, to provide a closed circuitway for electrons to flow from the electron donor, through the donor member, through the electric field regulation junction, through the acceptor member, through the electron acceptor, and through the conductive medium to the electron donor. The conductive medium may include an aqueous solution, or may include a conductive wire, for example.

Changing the state of the electric field regulator may include irradiating the regulator chromophore to cause a negative electrostatic potential to be produced and applied to the electric field regulation junction, the negative electrostatic potential decreasing the ability of an electron to travel from the donor member to the acceptor member.

The electric field regulator may include an electrode, which may be operable to perform at least one of accepting an electron from the acceptor member and donating an electron to the donor member.

Changing the state of the electric field regulator may include depositing an electron onto the electrode to produce a negative electrostatic potential applied to the electric field regulation junction, the negative electrostatic potential decreasing the ability of an electron to travel from the donor member to the acceptor member.

Conversely, changing the state of the electric field regulator may include removing an electron from the electrode to produce a positive electrostatic potential applied to the electric field regulation junction, the positive electrostatic potential increasing the ability of an electron to travel from the donor member to the acceptor member.

The electric field regulator may include a plurality of states, each state of the plurality of states being selectable in response to an applied external potential to produce a respective electrostatic potential at the electric field regulation junction.

In accordance with another aspect of the invention, there is provided an apparatus for regulating an electronic signal between first and second locations in a conductive nucleic acid material. The apparatus includes the conductive nucleic acid material having the first and second locations, and further includes means for varying an electrostatic potential at a third location in the nucleic acid material interposed between the first and second locations.

The means for varying may include means for selecting one of a plurality of states of an electric field regulator in communication with the third location, each of the states corresponding to a respective electrostatic potential at the third location.

The means for selecting may include means for irradiating the electric field regulator.

Alternatively, the means for selecting may include means for applying an external potential to the electric field regulator.

The electric field regulator may include an electrode, in which case the means for applying may include means for depositing at least one electron onto the electrode to apply a negative electrostatic potential to the third location.

Alternatively, or in addition, the means for applying may include means for removing at least one electron from the electrode to apply a positive electrostatic potential to the third location.

The apparatus may further include means for producing the electronic signal.

The first location may include a location in a conductive nucleic acid electron donor member, the second location may include a location in a conductive nucleic acid electron acceptor member, and the third location may include at least one electric field regulation junction in electrical communication with the donor member and the acceptor member. In such a case, the means for varying may include means for varying the electrostatic potential at the at least one electric field regulation junction.

The least one electric field regulation junction may be in electrical communication with a conductive nucleic acid electric field regulator member. If so, the means for varying may include means for selecting one of a plurality of states of an electric field regulator in electrical communication with the regulator member, each of the states corresponding to a respective electrostatic potential at the at least one electric field regulation junction.

The means for selecting may include means for irradiating the electric field regulator.

Alternatively, the means for selecting may include means for applying an external potential to the electric field regulator. For example, the electric field regulator may include an electrode, and the means for applying may include means for depositing at least one electron onto the electrode to apply a negative electrostatic potential to the electric field regulation junction, the negative electrostatic potential decreasing the ability of an electron to travel from the donor member to the acceptor member. Alternatively, or in addition, the means for applying may include means for removing at least one electron from the electrode to apply a positive electrostatic potential to the electric field regulation junction, the positive electrostatic potential increasing the ability of an electron to travel from the donor member to the acceptor member.

In accordance with another aspect of the invention, there is provided an apparatus for regulating an electronic signal between first and second locations in a conductive nucleic acid material. The apparatus includes an electric field regulator operable to vary an electrostatic potential at a third location in the nucleic acid material interposed between the first and second locations.

The electric field regulator may have a plurality of selectable states, each of the states corresponding to a respective electrostatic potential at the third location.

The electric field regulator may include an electrode. Alternatively, the electric field regulator may include a chromophore, or may include a fluorescent molecule such as fluorescein or rhodamine for example, or may be selected from the group consisting of fluorescent molecules and chromophores, for example.

The first location may include a location in a conductive nucleic acid electron donor member, the second location may include a location in a conductive nucleic acid electron acceptor member, and the third location may include at least one electric field regulation junction in electrical communication with the donor member, the acceptor member, and the electric field regulator.

The apparatus may further include a regulator member joining the electric field regulator to the electric field regulation junction.

In accordance with another aspect of the invention, there is provided a method of regulating an electronic signal in a conductive nucleic acid material. The method includes varying a degree of electric field regulation at an electric field regulation junction at which a regulator member intersects at least one of a plurality of members. Each of the regulator member and the plurality of members includes an oligonucleotide duplex, and at least some of the regulator member and the plurality of members includes a conductive metal-containing oligonucleotide duplex. The plurality of members includes at least one donor member for receiving conduction electrons from an electron donor, and at least one acceptor member for communicating with an electron acceptor to provide a region of attraction for the conduction electrons.

Varying may include varying an electrostatic potential at the electric field regulation junction.

Varying may include selecting one of a plurality of states of an electric field regulator in communication with the electric field regulation junction via the regulator member.

Selecting may include irradiating the electric field regulator, or may include applying an external potential to the electric field regulator, for example.

In the following, there is described a method of storing data. The method includes selecting one of at least two states of an electric field regulator of a nucleic acid circuit element, each of the at least two states corresponding to a respective degree of electric field regulation at an electric field regulation junction in the circuit element, each degree of electric field regulation corresponding to a respective data value.

Selecting may include irradiating the electric field regulator, or may include applying an external potential to the electric field regulator, for example.

The nucleic acid circuit element may include a plurality of members, at least some of which may include a conductive metal-containing oligonucleotide duplex. The plurality of members may include at least one donor member for receiving conduction electrons from an electron donor, at least one acceptor member for communicating with an electron acceptor to provide a region of attraction for the conduction electrons, and at least one regulator member intersecting with at least one of the plurality of members to define the electric field regulation junction, the regulator member being in communication with the electric field regulator. In such a case, selecting may include causing the electric field regulation junction to apply the degree of electric field regulation to the electric field regulation junction, to represent the data value.

An organic data storage medium an electric field regulator having at least two selectable states, each of the states corresponding to a respective degree of electric field regulation at an electric field regulation junction of a nucleic acid circuit element, each degree of electric field regulation corresponding to a respective data value.

The organic data storage medium may further include the nucleic acid circuit element, which in turn may include a plurality of members, at least some of which may include a conductive metal-containing oligonucleotide duplex. The plurality of members may include at least one donor member for receiving conduction electrons from an electron donor, at least one acceptor member for communicating with an electron acceptor to provide a region of attraction for the conduction electrons, and at least one regulator member intersecting with at least one of the plurality of members to define the electric field regulation junction, for cooperating with the electric field regulator to apply the degree of electric field regulation to the junction, to represent the data value.

The at least two states may be selectable by irradiating the electric field regulator, or by applying an external potential to the electric field regulator, for example.

Each of the at least two states may correspond to a respective electrostatic potential at the electric field regulation junction.

An apparatus for storing data includes a conductive nucleic acid circuit element comprising an electric field regulation junction, and further includes means for varying a degree of electric field regulation at the electric field regulation junction in the circuit element, each degree of electric field regulation corresponding to a respective data value.

The means for varying may include means for varying an electrostatic potential at the electric field regulation junction.

### BRIEF DESCRIPTION OF THE DRAWINGS

In drawings which illustrate embodiments of the invention,
- Figure **1**: is a graphical representation of an organic circuit element.
- Figure **2**: is a pictorial representation of a modeled structure of M-DNA as part of the organic circuit element depicted in Figure **1**.
- Figure **3**: is a pictorial depiction of a base pair scheme for M-DNA shown in Figure **2** as part of the organic circuit element of Figure **1**.
- Figure **4**: is a pictorial depiction of a base pairing scheme for M-DNA shown in Figure 2 as part of the organic circuit element shown in Figure **1.**
- Figure **5**: is a graphical representation of current voltage characteristics measured on M-DNA shown in Figure **2** and B-DNA at room temperature. The lower inset shows a schematic diagram of an experimental layout used to produce *I-V* characteristics.
- Figure **6**: is a graphical representation of an organic circuit element.
- Figure **7**: is a graphical representation of an organic circuit element.
- Figure **8**: is a graphical representation of an organic circuit element.
- Figure **9**: is a graphical representation of an organic circuit element.
- Figure **10**: is a graphical representation of an organic circuit element. according to a
- **Figure 11:**: a) Structures of 9,10-anthraquinone-2-carboxylic acid and 9,10-dihydroanthraquinone-2-carboxylic acid, and b) schematic of the Y-branched junctions.
- **Figure 12:**: Absorbance spectra of 30 µM AQ-NHS is 20 mM Tris-HCl, pH 8.5 buffer; 0 mM NaBH₄ (solid), 2.5 mM NaBH₄ (dashed), + O₂ (dotted). The normalized emission spectrum of fluorescein (dash-dot) is included for reference.
- **Figure 13:**: Electrophorgram demonstrating the effect of anthraquinone reduction on the FI-30-Aq duplex. Lane 1, DNA Molecular Weight Marker VIII; lane 2, empty; lanes 3 and 6, 2.5 mM NaBH₄; lane 4, 25 mM NaBH₄; lanes 5 and 7, 0 mM NaBH₄. For lanes 3-5, reduction carried out prior to hybridization; for lanes 6-7, reduction carried out after hybridization.
- **Figure 14:**: Normalized fluorescence for the Fluorescein/Anthraquinone labeled 30-mer as a function of NaBH4 used to reduce the AQ-labeled single strand. The reduction procedure was carried out prior to hybridization. For all measurements [DNA] = 0.5 µg mL⁻¹; [Zn²⁺] = 0.2 mM; pH 8.49 in 20 mM Tris-HCl buffer.

### DETAILED DESCRIPTION

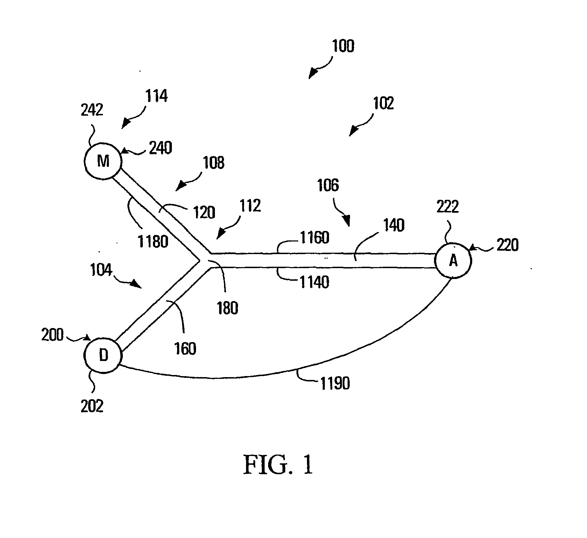

Referring to Figure **1,** an organic circuit element according to a first embodiment of the invention is shown generally at **100.** In this embodiment, the organic circuit element **100** includes a plurality **102** of members, each of which includes an oligonucleotide duplex. More particularly, in this embodiment the plurality **102** of members includes at least one donor member **104** for receiving conduction electrons from an electron donor **200,** and at least one acceptor member **106** for communicating with an electron acceptor **220** to provide a region of attraction for the conduction electrons. In this embodiment, the plurality **102** of members further includes at least one regulator member **108** intersecting with at least one of the plurality **102** of members to define at least one electric field regulation junction **112,** for cooperating with an electric field regulator **114** to regulate an electric field at the electric field regulation junction **112.**

In this embodiment, at least some of the plurality of members include a conductive metal-containing oligonucleotide duplex. More particularly, in this embodiment, each of the plurality of members includes a conductive metal-containing oligonucleotide duplex.

In the present embodiment, the plurality **102** of members includes a plurality of arms. More particularly, in this embodiment the donor member **104** includes a donor arm **160** electrically coupled to the electron donor **200** ("D") to provide a source of conduction electrons. The acceptor member **106** of the present embodiment includes an acceptor arm **140** electrically coupled to the electron acceptor **220** ("A") to provide a region of attraction for the conduction electrons. In this embodiment, the regulator member **108** includes a modulator arm **120** electrically coupled to the electric field regulator **114,** which in this embodiment includes an electron flow modulator **240** ("M") to regulate the flow of the conduction electrons from the electron donor, through the electric field regulation junction **112,** to the electron acceptor **220.**

In this embodiment, the donor member **104,** the acceptor member **106** and the regulator member **108** intersect to define the electric field regulation junction **112.** Thus, in the present embodiment the electric field regulation junction **112** includes a conductive junction **180,** which forms a three-arm junction connecting the arms **120, 140** and **160,** which extend from the conductive junction. However, the conductive junction may include more than three members in alternative embodiments.

In this embodiment, the organic circuit element **100** includes the electric field regulator **114** in electrical communication with the regulator member **108,** the electron donor **200** in electrical communication with the donor member **104,** and the electron acceptor **220** in electrical communication with the acceptor member **106.**

In the present embodiment, the electric field regulator **114** includes a plurality of selectable states, each of the states corresponding to a respective electrostatic potential at the at least one electric field regulation junction **112.** More particularly, in the present embodiment, the electric field regulator **114,** which in this embodiment includes the electron flow modulator **240,** has various states, each state of the plurality of states being selectable in response to an applied external potential to produce a respective electrostatic potential at the electric field regulation junction **112.** Alternatively, the states of the electron flow modulator may be selectable or changeable in any other suitable way, such as by irradiating the electron flow modulator for example, as discussed in greater detail below.

In various exemplary embodiments, the state of the electron flow modulator **240** may for example be any macroscopic or microscopic variable effective in determining the quantum-mechanical wave function of the electron flow modulator. For example, the state of the electron flow modulator **240** may represent the number of electrons added to or removed from the electron flow modulator, or the magnitude and/or direction of an external potential applied to the electron flow modulator. Moreover, the state of the electron flow modulator **240** may represent the orbital level of a valence electron on the electron flow modulator, or further properties of the orbital, such as a degeneracy level. Alternatively or in addition, the state of the electron flow modulator **240** may include a total spin of the electrons on the electron flow modulator or any other parameter sets indicating the quantum mechanical wave function identifying the state of the electron flow modulator.

The state of the electron flow modulator **240** may be selectable or changeable to vary an electrostatic potential at the conductive junction **180,** joining the modulator arm **120,** the donor arm **160,** and the acceptor arm **140,** to regulate electron flow or conductivity from the electron donor **200** to the electron acceptor **220.** The state of the electron flow modulator **240** may be changeable, for example, by applying an external potential to the electron flow modulator or depositing or removing electrons to or from its outer valence orbitals. Electron flow may represent an electronic signal, such as electron transport as in a DC signal, or a modulated voltage or current signal, or any other signal modulated to carry information. Thus, when the state of the electron flow modulator **240** is changed to vary the electrostatic potential at the conductive junction **180,** the electron flow or conductivity from the electron donor **200** to the electron acceptor **220** through the conductive junction **180** may be modulated to thereby regulate a signal passed from the electron donor arm to the electron acceptor arm.

In this embodiment, the organic circuit element **100** includes a conductive nucleic acid material. More particularly, in the present embodiment, each of the donor member **104,** the regulator member **108** and the acceptor member **106** includes a conductive metal-containing nucleic acid duplex portion. More particularly still, in this embodiment the donor arm **160,** the modulator arm **120** and the acceptor arm **140** each includes a conductive metal-containing oligonucleotide duplex which is able to conduct electrons.

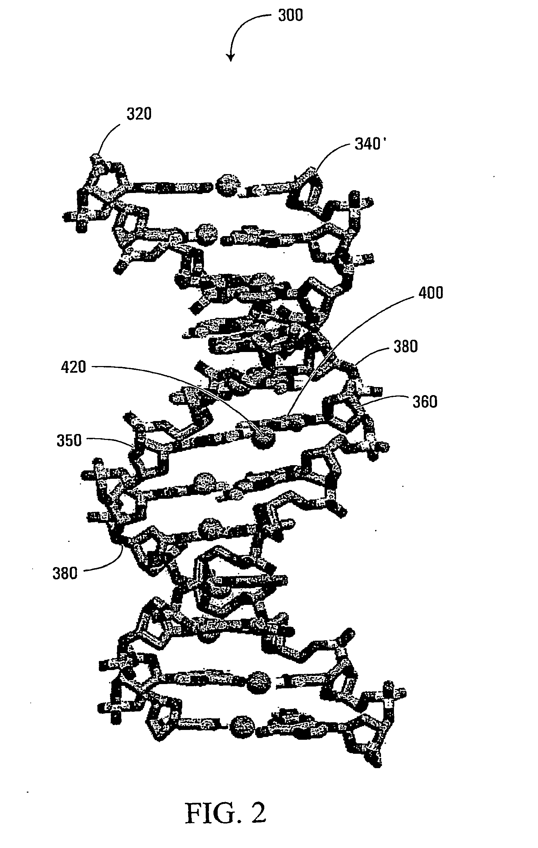

An example of a conductive metal-containing oligonucleotide duplex ("M-DNA") is shown at **300** in Figure **2.** In this embodiment, the M-DNA **300** includes a first nucleic acid strand **320** and a second nucleic acid strand **340**. The first and second nucleic acid strands **320** and **340** include respective pluralities of nitrogen-containing aromatic bases **350** and **360,** covalently linked by a backbone **380.** The nitrogen-containing aromatic bases **350** of the first nucleic acid strand **320** are joined by hydrogen bonding to the nitrogen-containing aromatic bases **360** of the second nucleic acid strand **340.** The nitrogen-containing aromatic bases **350** and **360** on the first and the second nucleic acid strands **320** and **340,** respectively, form hydrogen bonded base pairs **400** in stacked arrangement along a length of the conductive metal-containing oligonucleotide duplex **300.** The hydrogen-bonded base pairs **400** include an interchelated metal cation **420** coordinated to a nitrogen atom in one of the nitrogen-containing aromatic bases **350** or **360.** More particularly, in this embodiment the interchelated metal cation includes an interchelated divalent metal cation. In the present embodiment, the first and second nucleic acid strands **320** and **340** respectively include deoxyribonucleic acid and the nitrogen-containing aromatic bases **350** and **360** are selected from the group consisting of adenine, thymine, guanine and cytosine.

Alternatively, other backbone structures **380** may be effective to appropriately align the nitrogen-containing aromatic bases **350, 360** in a stacked arrangement capable of chelating metal ions **420** and conducting electrons. For example, phosphoramide, phosphorothioate, phosphorodithioate, O-methylphosphoroamidite or peptide nucleic acid linkages may be effective to form such a backbone. Similarly, other components of the backbone **380** may vary, encompassing the deoxyribose moieties, ribose moieties, or combinations thereof, for example.

Alternatively, other types of bases may be substituted. For example, the nitrogen-containing aromatic bases **350** and **360** may be those that occur in native DNA and RNA, and thus, the nitrogen-containing aromatic bases may be selected from the group consisting of adenine, thymine, cytosine, guanine or uracil, or variants thereof such as **5**-fluorouricil or **5**-bromouracil. Alternative aromatic compounds may be utilized, such as aromatic compounds capable of interchelating a divalent metal ion coordinated to an atom in the aromatic compound, and capable of stacking, to produce a conductive metal-containing oligonucleotide duplex. Alternative aromatic compounds may for example include: **4**-acetylcytidine; **5-**(carboxyhydroxymethyl) uridine; **2'**-O-methylcytidine; **5-**carboxymethylaminomethyl-**2**-thiouridine; **5-**carboxymethylaminomethyluridine; dihydrouridine; **2'**-O-methylpseudouridine; beta, D-galactosylqueuosine; **2**'-O-methylguanosine; inosine; N**6-**isopentenyladenosine; **1**-methyladenosine; **1**-methylpseudouridine; **1-**methylguanosine; **1**-methylinosine; **2,2**-dimethylguanosine; **2-**methyladenosine; **2**-methylguanosine; **3**-methylcytidine; **5**-methylcytidine; N**6-**methyladenosine; **7**-methylguanosine; **5**-methylaminomethyluridine; **5-**methoxyaminomethyl-**2**-thiouridine; beta, D-mannosylqueuosine; **5-**methoxycarbonylmethyl-**2**-thiouridine; **5**-methoxycarbonylmethyluridine; **5-**methoxyuridine; **2**-methylthio-N**6**-isopentenyladenosine; N-((**9**-beta-D-ribofuranosyl-**2**-methylthiopurine-**6**-yl)carbamoyl)threonine; N-((**9**-beta-D-ribofuranosylpurine-**6**-yl) N-methycarbamoy**1**)threonine; uridine-**5**-oxyacetic acid-methylester-, uridine-**5**-oxyacetic acid; pseudouridine; queuosine; **2-**thiocytidine; **5**-methyl-**2**-thiouridine; **2**-thiouridine; **4**-thiouridine; **5-**methyluridine; N-((**9**-beta-D-ribofuranosylpurine-**6**-yl)-carbamoyl) threonine; **2'**-O-methyl-**5**-methyluridine; and **2'**-O-methyluridine; **3**-(**3**-amino-**3**-carboxypropyl) uridine; hypoxanthine, **6**-methyladenine, **5**-me pyrimidines, particularly **5**-methylcytosine (also referred to as **5**-methyl-**2'**deoxycytosine and often referred to in the art as **5**-me-C), 5-hydroxymethylcytosine (HMC), glycosyl HMC and gentobiosyl HMC, as well as synthetic nucleobases, e.g., **2-**aminoadenine, **2**-thiouracil, **2**-thiothymine, **5**-bromouracil, **5-**hydroxymethyluracil, **8**-azaguanine, **7**-deazaguanine, N⁶ (**6-**aminohexyl)adenine and **2,6**-diaminopurine.

In some embodiments, as for example illustrated in Figure **2,** the estimated spacing between the divalent metal ions **420** may be about **3**, **4** or **5** Å (Angstroms).

The oligonucleotides may include those containing modified backbones, for example, phosphorothioates, phosphotriesters, methyl phosphonates, short chain alkyl or cycloalkyl intersugar linkages or short chain heteroatomic or heterocyclic intersugar linkages. In some embodiments, the phosphodiester backbone of the oligonucleotide may be replaced with a polyamide backbone, the nucleobases being bound directly or indirectly to the aza nitrogen atoms of the polyamide backbone (Nielsen et al., Science, **1991, 254, 1497**). Oligonucleotides may also contain one or more substituted sugar moieties, such as moieties at the **2'** position: OH, SH, SCH₃, F, OCN, OCH₃ OCH₃, OCH₃ O(CH₂)ₙ, CH₃, O(CH₂)ₙ, NH₂ or O(CH₂)ₙ, CH₃ where n may for example be from **1** to about **10;** C₁ to C₁₀ lower alkyl, alkoxyalkoxy, substituted lower alkyl, alkaryl or aralkyl; Cl; Br; CN; CF₃ ; OCF₃ ; O-, S-, or N-alkyl; O-, S--, or N-alkenyl; SOCH₃ ; SO₂ CH₃ ; ONO₂ ; NO₂ ; N₃ ; NH₂ ; heterocycloalkyl; heterocycloalkaryl; aminoalkylamino; polyalkylamino; substituted silyl; an RNA cleaving group; a reporter group; an intercalator; and other substituents having similar properties. Similar modifications may also be made at other positions on the oligonucleotide, particularly the **3'** position of the sugar on the **3'** terminal nucleotide and the **5'** position of **5'** terminal nucleotide. Oligonucleotides may also have sugar mimetics such as cyclobutyls in place of the pentofuranosyl group. Oligonucleotides may also include, additionally or alternatively, nucleobase (often referred to in the art simply as "base") modifications or substitutions.

If desired, the divalent metal cations may be substituted for imine protons of the nitrogen-containing aromatic bases, and the nitrogen-containing aromatic bases are selected from the group consisting of thymine and guanine.

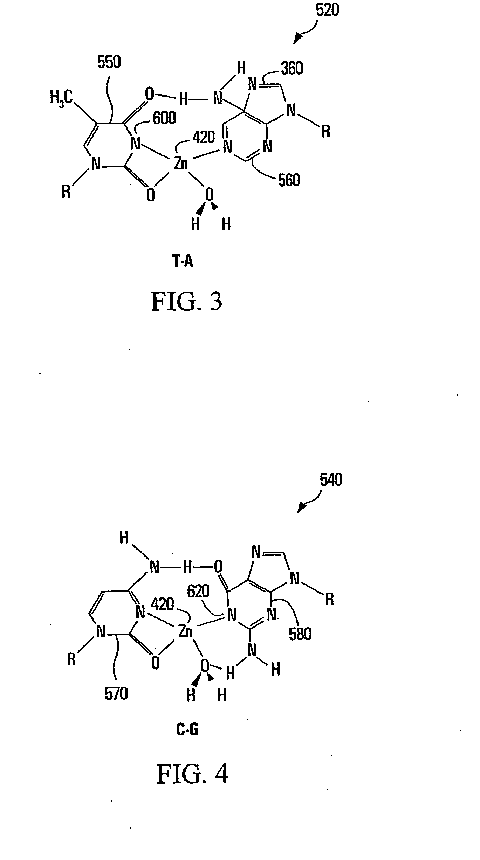

Referring to Figure **3,** a base-pairing scheme for the M-DNA **300** according to the present embodiment is shown generally at **520.** In the base-pairing scheme **520,** at least one of the nitrogen-containing aromatic bases includes thymine, having an **N3** nitrogen atom, and the divalent metal cation is coordinated by the **N3** nitrogen atom. More particularly, in this embodiment the base-pairing scheme **520** includes a thymine-adenine base pair, and the divalent metal cation **420** is zinc. Alternatively, the divalent metal cation **420** may be selected from the group consisting of zinc (Zn²⁺), cobalt (Co²⁺) and nickel (Ni²⁺). Alternatively, other divalent metal ions may be substituted depending upon the ability of the ions to participate with the other substituents in the formation of a conductive metal-containing oligonucleotide duplex. Alternatively, the metal cation may be selected from the group consisting of the cations of Li, Be, Na, Mg, Al, K, Ca, Sc, Ti, V, Cr, Mn, Fe, Co, Ni, Cu, Zn, Ga, Ge, As, Rb, Sr, Y, Zr, Nb, Mo, Tc, Ru, Rh, Pd, Ag, Cd, In, Sn, Sb, Cs, Ba, La, Ce, Pr, Nd, Pm, Sm, Eu, Gd, Tb, Dy, Ho, Er, Tm, Yb, Lu, Hf, Ta, W, Re, Os, Ir, Pt, Au, Hg, Tl, Pb, Bi, Po, Fr, Ra, Ac, Th, Pa, U, Np and Pu. For example, in some embodiments, varying amounts of metal cations may be incorporated into a duplex, such as Zn²⁺, Ni²⁺, Co²⁺, Cd²⁺, Hg²⁺, Pt²⁺ and Ag¹⁺, where metal ions such as Cd²⁺, Hg²⁺, Pt²⁺ and Ag¹⁺ may constitute only a portion of the metal ions in the duplex, in effect 'doping' the duplex. The formation of a metal-substituted duplex using alternative cations under alternative conditions may be monitored, for example, using an ethidium bromide fluorescence assay.

In this embodiment, in the thymine-adenine base pair of the base-pairing scheme **520** shown in Figure **3**, one nitrogen-containing aromatic base is thymine **550** which possesses an **N3** nitrogen atom **600.** The divalent metal cation **420** (which in this embodiment is zinc) is coordinated by the **N3** nitrogen atom **600** of the thymine **550,** where the divalent metal cation zinc is substituted for an imine proton of the nitrogen-containing aromatic base.

Referring to Figure **4,** a base-pairing scheme for M-DNA according to a second embodiment of the invention is shown generally at **540.** In the embodiment shown in Figure **4,** at least one of the nitrogen-containing aromatic bases includes guanine, having an **N1** nitrogen atom, and the divalent metal cation is coordinated by the **N1** nitrogen atom. More particularly, in this embodiment the base-pairing scheme **540** includes a cytosine-guanine base pair, in which one of the nitrogen-containing aromatic bases is guanine **580,** which has an **N1** nitrogen atom **620.** As with the embodiment shown in Figure **3,** in this embodiment the divalent metal cation **420** is zinc. Alternatively, the divalent metal cation **420** may be selected from the group consisting of zinc (Zn²⁺), cobalt (Co²⁺) and nickel (Ni²⁺), or may include other suitable cations. In this embodiment, the divalent metal cation **420,** which in this embodiment is zinc, is coordinated by the **N1** nitrogen atom. Alternatively, the divalent metal cation **420** may be complexed between aromatic moieties in alternative conformations. In some embodiments, as illustrated, the imino protons of each base pair may be replaced by a metal ion.

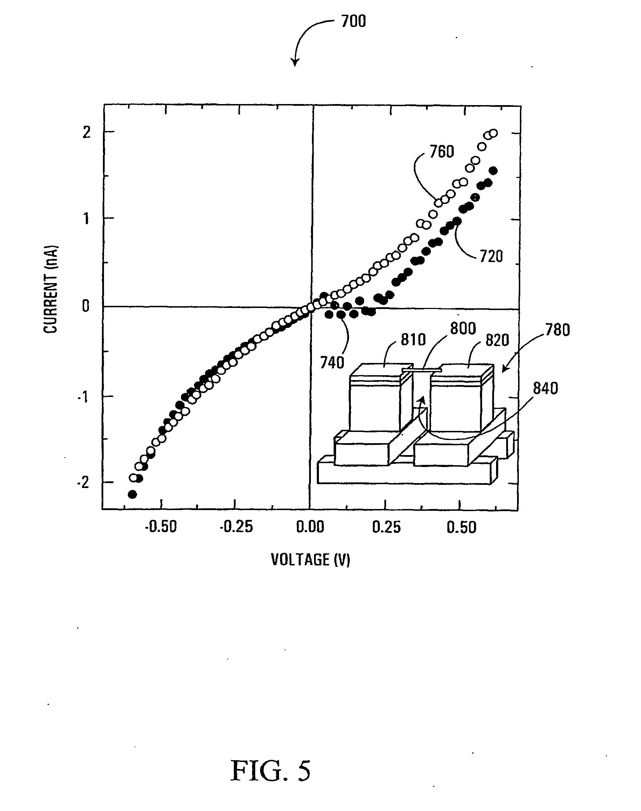

Referring to Figure **5,** the electrical (I-V) characteristics of an M-DNA may be measured as shown in Figure **5,** and as disclosed in Rakitin et al., **2000.** For example, M-DNA may be prepared, such as the M-DNA prepared by Rakitin et al., from a B-DNA form of phage λ-DNA in **0.1** mM Zn²⁺ at a pH of **9.0**, having sticky ends which can be utilized to bind each end in turn to an individual metallic electrode, such as a source electrode **810** and a drain electrode **820,** which in this embodiment include gold electrodes (Braun et al., **1998**).

A schematic testing layout to provide conductivity measurements of M-DNA is shown generally at **780** in the inset in Figure **5.** In this arrangement, a nucleic acid **800** is placed between the source electrode **810** and the drain electrode **820** separated by a deep physical gap **840,** which may for example have a width of **1-30** microns.

Examples of *I-V* characteristics measured in vacuum (**10⁻³** torr) at room temperature on samples of M-DNA and B-DNA are shown together generally at **700** in Figure **5.** A curve corresponding to B-DNA **720** shows a semiconductor like plateau (a band gap or conductance gap **740**) of about **200** meV. In contrast, the I-V characteristic for M-DNA **760** shows no conductance gap. This is a characteristic difference between metallic and insulating behavior showing that electrons in M-DNA can conduct current down to extremely low voltages while B-DNA cannot. Thus, the qualitative difference in I-V characteristics of M-DNA **760** and B-DNA **720** at low bias voltages are indicative of a difference in their conduction mechanism.

In this embodiment, the M-DNA **300** is formed by annealing and treating a plurality of oligonucleotides to form a plurality of members, each member of the plurality of members including a pair of the oligonucleotides aligned to form a duplex portion. More particularly, in this embodiment the plurality of members include the donor member **104,** the acceptor member **106,** and the regulator member **108,** and the annealing and treating of the plurality of oligonucleotides forms the members in a configuration in which the donor member, the acceptor member and the regulator member intersect to define the electric field regulation junction **112.**

In the present embodiment, the oligonucleotides are annealed in conditions effective to form the duplex portion, and are treated in conditions effective to form the electric field regulation junction. More particularly, in this embodiment annealing includes subjecting the plurality of oligonucleotides to a basic solution under conditions effective to form the conductive metal-containing oligonucleotide duplex portion. In this embodiment, the conditions effective to form the conductive metal-containing oligonucleotide or nucleic acid duplex portion are effective to substitute the divalent metal cations for an imine proton of a nitrogen containing aromatic base in the conductive metal-containing oligonucleotide duplex portion. Thus, in this embodiment, producing the conductive metal-containing nucleic acid duplex includes subjecting the nucleic acid duplex to a basic solution in the presence of a metal cation (which in this embodiment is a divalent metal cation) under conditions effective to form the conductive metal-containing nucleic acid duplex, wherein the hydrogen-bonded base pairs of the conductive metal-containing nucleic acid duplex include an interchelated metal cation coordinated to a nitrogen atom in one of the nitrogen-containing aromatic bases. Similarly, in this embodiment, treating the plurality of oligonucleotides includes subjecting the nucleotides to the basic solution under conditions effective to form the electric field regulation junction. In the present embodiment, the basic solution has a pH of at least **7**.

More generally, the conditions effective to form the M-DNA **300** will vary depending on the divalent metal cation **420** or ions used and the nature of the nucleic acid strands **320** and **340.** Routine assays may be carried out to determine appropriate conditions effective for conductive duplex formation, for example by varying parameters such as pH, nucleic acid concentration, metal ion concentration, and the ratio of the metal ion concentration to the nucleic acid concentration. In some embodiments, a pH equal to or greater than **7, 7.5, 8, 8.5** or **9** may be desirable, and a suitable nucleic acid to metal ion ratio may be from about **1:1.5** to about **1:2.0,** for example.

In some embodiments, M-DNA **300** may be formed from B-DNA by the addition of metal ions, such as **0.1**mM Zn²⁺ or mM NiCl₂ at an approximate pH, such as a pH of **9.0.** There may be a concomitant release of protons, so that a base such as KOH may be added to maintain the pH at a desired level, such as at **8.**

As is evidenced by the conductive behaviour shown in Figure **5,** configurations of conductive M-DNA may provide switching functionality of current and/or voltage to regulate electronic signals.

Referring back to Figure **1,** in this embodiment the three arms **120, 140** and **160** intersecting to define the conductive junction **180** enable the organic circuit element **100** to function as an electric signal regulator. Three-way junctions such as the conductive junction **180** may for example be prepared from three strands of oligonucleotides **1140, 1160** and **1180,** each having **5'** and **3'** ends, the sequences of which may be chosen so that they can only anneal in the desired configuration. In the embodiment shown in Figure **1,** the three-way conductive junction **180** was constructed from the three strands of oligonucleotides **1140, 1160** and **1180,** which in this embodiment include three **60**-mer oligonucleotides, forming duplex portions (namely, the modulator arm **120,** the acceptor arm **140,** and the donor arm **160**) out of pairs of antiparallel oligonucleotides.

Still referring to Figure **1,** in this embodiment, the electron donor **200** includes a first electrode **202** operable to donate an electron to the donor member **104,** and the electron acceptor **220** includes a second electrode **222** operable to accept an electron from the acceptor member **106.** Also in this embodiment, the electric field regulator **114,** or more particularly the electron flow modulator **240,** includes a third electrode **242.** If desired, the third electrode may be operated to accept an electron from the acceptor member or to donate an electron to the donor member. The electrodes **202, 222** and **242** may include gold electrodes, for example. Gold electrodes may for example be attached to DNA by incorporating a thiol at the **5'** end in place of the chromophore (Wang et al., **1999**). A current or voltage may be externally applied to the organic circuit element **100** across the donor arm **160** and the acceptor arm **140.**

Alternatively, the electron donor, electron acceptor and electric field regulator need not include electrodes.

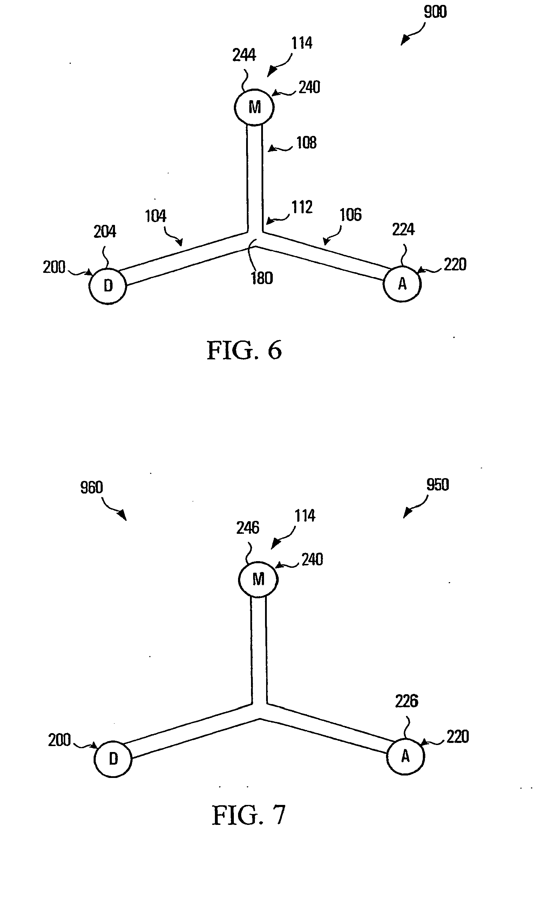

For example, referring to Figures **1** and **6,** an organic circuit element according to a third embodiment of the invention is shown generally at **900** in Figure **6.** The organic circuit element **900** is generally similar to the organic circuit element **100** shown in Figure **1,** however, in the embodiment shown in Figure **6,** the electron donor **200** of the organic circuit element **900** includes an electron donor molecule **204** capable of donating an electron to the donor member **104** (which in this embodiment includes the donor arm **160**). In the present embodiment the electron donor molecule **204** includes a fluorescent molecule, or more particularly, a fluorescein. Similarly, the electron acceptor **220** of the organic circuit element **900** includes an electron acceptor molecule **224** capable of accepting an electron from the acceptor member **106** (which in this embodiment includes the acceptor arm **140**). In the present embodiment, the electron acceptor molecule **224** also includes a fluorescent molecule, or more particularly, a rhodamine. Also in this embodiment, the electric field regulator **114,** or more particularly the electron flow modulator **240,** includes a regulator molecule **244** selected from the group consisting of fluorescent molecules and chromophores. Thus, in this embodiment, the states of the electric field regulator **114** may be selected by irradiating the electric field regulator. More particularly, in this embodiment the regulator molecule **244** includes a fluorescent molecule, such as a fluorescein or a rhodamine, for example. Alternatively, other suitable regulator molecules may be substituted.

Similarly, referring to Figures **1** and **7,** an organic circuit element according to a fourth embodiment of the invention is shown generally at **950** in Figure **7.** In this embodiment, the electric field regulator **114,** or more particularly, the electron flow modulator **240,** includes a regulator or modulator chromophore **246,** which in this embodiment absorbs radiation within a range of wavelengths. Thus, the states of the electric field regulator **114** may be selected by irradiating the electric field regulator. In this embodiment, irradiating the modulator chromophore **246** causes a negative electrostatic potential to be applied to the electric field regulation junction **112,** the negative electrostatic potential decreasing the ability of an electron to travel from the donor member **104** to the acceptor member **106.** Similarly, in this embodiment the electron acceptor **220** includes a chromophore **226** operable to emit radiation within a range of wavelengths in response to accepting an electron from the acceptor member **106.**

Similarly, in other embodiments, the electric field regulator **114,** the electron donor **200** and the electron acceptor **220** may include any other suitable combinations or permutations of electrodes, fluorescent molecules, chromophores, or other suitable molecules. In this regard, fluorescent molecules and electrodes may be particularly useful in combination for some applications of embodiments of the present invention, due to the ability of fluorescent molecules to generate photocurrents when irradiated and subjected to an applied potential. For example, it has been found that fluorescein-labelled M-DNA assembled on a gold electrode and subjected to an applied potential of **0.2** volts generates an appreciable photocurrent of approximately **0.03** mA when the fluorescein is irradiated, but does not generate any appreciable photocurrent when the fluorescein is not being irradiated. (At higher potentials, however, some current may be observed regardless of irradiation, due to electrolysis.) Similarly, irradiation of chromophore-labelled M-DNA attached to a gold electrode also produces an appreciable current.

In some such exemplary embodiments, the **5**' end of each arm **120, 140** and **160** was attached either to fluorescein, rhodamine or a control, not labeled. As used herein, a nomenclature for labeled circuit elements may be based on identifying each arm **120, 140** and **160** with a letter (F, R, or C) to specify whether that arm contains, respectively, fluorescein (F), rhodamine (R) or a control (C, no label). Thus, for example, **160F:120C:140R-60** represents three **60-**mer oligonucleotide strands **1140, 1160** and **1180** assembled to form the conductive junction **180,** where fluorescein is the electron donor **200** attached to the donor arm **160,** rhodamine is the electron acceptor **220** connected to the acceptor arm **140,** and the electron flow modulator **240** is absent and therefore not connected to the modulator arm **120.**

The fluorescence of the electron donor **200** of the organic circuit element **100** may then be measured by fluorescence assay to confirm the conductivity of the junction **180.** During such an assay, the fluorescence will be quenched if there is electron transfer along the M-DNA, through the junction. If, on the other hand, there is little conduction along the donor arm **160** and the acceptor arm **140** (as would be the case if these arms had been formed of B-DNA rather than M-DNA for example), the fluorescence of the electron donor **200** will not be quenched to the same degree. In one such exemplary embodiment, the fluorescence of fluorescein acting as the electron donor **200** was measured for M-DNA **160F:120C:140R-60** and compared to another exemplary embodiment, **160F:120C:140C-60,** which has the same configuration except that the latter embodiment does not include rhodamine acting as the electron acceptor **220** connected to the acceptor arm **140.** The fluorescein fluorescence was **40**% quenched for the former embodiment (**160F:120C:140R-60**) compared to the latter embodiment (**160F:120C:140C-60**), confirming that electrons are transferred from the fluorescein electron donor **200** through the donor arm **160** and the conductive junction **180** to the acceptor arm **140** and the rhodamine electron acceptor **220.**

Other such exemplary embodiments employing a fluorescent molecule as the electron donor **200** may be similarly used to confirm the ability of the electric field regulator **114** to regulate the electric field at the electric field regulation junction **112.** For example, two exemplary embodiments, **160F:120R:140R-60** and **160F:120F:140R-60,** having a rhodamine or a fluorescein as the electron flow modulator **240** connected to the modulator arm **120,** were separately compared to a control sample, **160F:120C:140R-60.** During respective fluorescence assays, the fluorescein fluorescence was quenched by **60**% (**160F:120R:140R-60**) and **35**% (**160F:120F:140R-60**) relative to the control sample. Therefore an electron donor or acceptor, such as fluorescein or rhodamine, attached to the modulator arm **120** can alter the conductivity between the donor arm **160** through the conductive junction **180** and to the acceptor arm **140.** Thus, the circuit element **100** may act as a switch having alternative states.

More generally, referring to Figures **1, 6** and **7,** any of the organic circuit elements **100, 900** and **950** (or the other organic circuit elements described in greater detail below, for example) may be used to regulate an electronic signal between first and second locations in a conductive nucleic acid material. In this embodiment, the first location may include the electron donor **200,** or alternatively, may be considered to include any location on the donor member **104** between the electron donor **200** and the electric field regulation junction **112.** Similarly, in this embodiment the second location may include the electron acceptor **220,** or any location on the acceptor member **106** between the electron acceptor **220** and the electric field regulation junction **112.** The electronic signal itself may be produced by causing electrons to flow from the first location to the second location, in any suitable way, such as by applying a voltage between the electron donor and the electron acceptor, irradiating the donor and acceptor, and/or supplying electrons to the first location and receiving electrons from the second location.

The regulation of the electronic signal between the first and second locations may be achieved by varying an electrostatic potential at a third location in the nucleic acid material interposed between the first and second locations. In the embodiments shown in Figures **1, 6** and **7,** the third location includes the electric field regulation junction **112.** The varying of the electrostatic potential may be achieved by selecting one of the plurality of states of the electric field regulator **114,** which is in communication with the third location, each of the states corresponding to a respective electrostatic potential at the third location. In the case of the organic circuit elements **900** and **950** shown in Figures **6** and **7,** selecting one of the states may be achieved by irradiating the electric field regulator. This may cause a negative electrostatic potential to be applied to the third location, for example. In the case of the organic circuit element **100** shown in Figure **1,** selecting one of the states may be achieved by applying an external potential to the electric field regulator **114,** or more particularly, to the electrode **242.** This may include depositing at least one electron onto the electrode **242** to apply a negative electrostatic potential to the third location, or alternatively, removing at least one electron from the electrode **242** to apply a positive electrostatic potential to the third location. A negative electrostatic potential at the electric field regulation junction **112** tends to decrease the ability of an electron to travel from the donor member to the acceptor member, while a positive electrostatic potential at the junction tends to increase its ability to do so. Thus, any of the circuit elements shown in Figures **1, 6** and **7** acts as an apparatus for regulating an electronic signal between first and second locations in a conductive nucleic acid material, the apparatus including an electric field regulator operable to vary an electrostatic potential at a third location in the nucleic acid material interposed between the first and second locations.

Referring back to Figure **7,** in alternative embodiments, a modulator chromophore **246** may be selected as the electric field regulator **114,** so that it absorbs irradiation at a wavelength that is different from the wavelengths at which both the electron donor and the electron acceptor, such as fluorescein and rhodamine, absorb irradiation. Upon selective irradiation of the modulator chromophore **246,** an electron is excited to a higher energy state on the modulator chromophore which thus produces a change in the conductivity or electrostatic potential (voltage) at the conductive junction **180.** In some embodiments, a negative electrostatic potential may be established at the conductive junction **180** which may impede conductivity or the passage of electrons through the conductive junction **180.** After some time, the modulator chromophore **246** may return to a different state, for example an excited electron in the chromophore **246** may emit a photon and fall back into its ground state, thus returning the electrostatic potential or conductivity at the conductive junction **180** to its original value (or a further alternative value). In this way, the conductive junction **180** may act as a gate to regulate the flow of signals or electrons from the donor arm **160** to the acceptor arm **140.** In one embodiment, for example, the conductive junction **180** may act as a gate switch which may be in an "on" state when the modulator chromophore is unirradiated and thus allows electrons or a signal to flow from the donor arm **160** to the acceptor arm **140,** and the gate may be in an "off" state when the modulator chromophore **246** is irradiated and its electron is excited to a higher energy state. Thus, in such embodiments, the organic circuit element **100** behaves in some ways analogously to a field effect transistor in which the electron donor **200** acts as a source electrode, the electron acceptor **220** acts as a drain electrode, and the electric field regulator **114** (such as the modulator chromophore **246**) acts as a gate electrode. The electric field regulator **114,** acting as a gate electrode, may act to control the effective electron diameter of a channel of electron flow flowing from the donor arm **160** through the conductive junction **180** to the acceptor arm **140.** Effectively, the flow of electrons from the electron donor **200** (source electrode) is controlled by the voltage or change in electrostatic potential applied by the electric field regulator **114** to the conductive junction **180.** The voltage applied to the conductive junction (gate) may be regulated or modulated by the electron flow modulator **240** and by the modulator arm **120.** By regulating the "on" and "off" state of the "gate switch" in this manner, to vary the electrostatic potential at the conductive junction **180,** the organic circuit element **100** may be used to create, store and erase memory by representing zeros and ones in the alternative states.

Thus, referring to Figure **7** for example, an organic data storage medium is shown generally at **960.** The storage medium **960** includes the electric field regulator **114,** which has at least two selectable states, each of the states corresponding to a respective degree of electric field regulation at an electric field regulation junction of a nucleic acid circuit element, each degree of electric field regulation corresponding to a respective data value. In this embodiment, the organic data storage medium **960** further includes the organic nucleic acid circuit element **950,** which in turn includes the donor member **104,** the acceptor member **106,** and the regulator member **108** intersecting with at least one of the plurality of members (in this embodiment, intersecting both the donor member and the acceptor member) to define the electric field regulation junction **112,** for cooperating with the electric field regulator **114** to apply the degree of electric field regulation to the junction, to represent the data value.

In this embodiment, each of the at least two states of the electric field regulator corresponds to a respective electrostatic potential at the electric field regulation junction.

In the present embodiment, the at least two states are selectable by irradiating the electric field regulator. More particularly, in this embodiment, the at least two selectable states include an excited state and a ground state of the chromophore **246.** The chromophore **246** may be maintained in an excited state by irradiating it, to represent a data value such as a binary **"1",** for example, and may be allowed to revert to its ground state by ceasing such irradiation, to represent a data value such as a binary **"0",** for example. As discussed above, when the chromophore is in the excited state, the electrostatic potential at the electric field regulation junction **112** is altered or varied, thereby altering the conductivity at the conductive junction **180.** The data value so stored may then be "read" in any suitable way. For example, an external potential may be applied between the electron donor **200** and the electron acceptor **220,** and the resulting current may be measured, a first measured current value being indicative of the excited state representing a binary **"1",** a second measured current value being indicative of the ground state representing a binary **"0".**

Referring back to Figure **1,** an alternative organic data storage medium may include the organic circuit element **100,** in which the at least two states are selectable by applying an external potential to the electric field regulator **114,** which in the embodiment shown in Figure 1 includes the electrode **242.**

More generally, however, many useful applications other than data storage exist for such methods of regulating an electronic signal in a conductive nucleic acid material by varying a degree of electric field regulation at an electric field regulation junction, as described above.

Referring back to Figure **1,** a system may be provided, the system including the organic circuit element **100** and further including a conductive medium **1190** for supplying conduction electrons to the electron donor **200** and for receiving conduction electrons from the electron acceptor **220.** In some such embodiments, a current may flow when an organic circuit element such as the circuit element **100** is included in the conductive medium **1190.** The conductive medium **1190** may be any medium which is operable to donate electrons to the electron donor **200** and accept electrons from the electron acceptor **220** to provide a closed circuit way for electrons to flow from the electron donor **200,** through the donor member **104** (in this embodiment, the donor arm **160**), through the electric field regulation junction **112** (which in this embodiment includes the conductive junction **180**), through the acceptor member **106** (which in this embodiment includes the acceptor arm **140**), through the electron acceptor **220,** and back to the electron donor. The conductive medium **1190** may include an aqueous solution, for example, to provide conduction between the electron donor **200** and the electron acceptor **220.** Alternatively, the conductive medium **1190** may include a conductive wire, for example, or any other suitable conductive medium may be substituted.

Referring back to Figure **1,** in alternative embodiments, not all of the plurality **102** of members necessarily include a conductive metal-containing oligonucleotide duplex. More particularly, one or more of the arms **120, 140** or **160** may not form a conductive duplex under conditions where one or more of the remaining arms, **120, 140** or **160** does form a conductive duplex. In one such embodiment, the donor member **104** and the acceptor member **106** may include such a conductive metal-containing oligonucleotide duplex, while one or more other members do not. For example, the modulator arm **120** may have a composition which will not form a conductive duplex when the donor arm **160** and the acceptor arm **140** do form a conductive duplex. In this way, combinations of B-DNA and M-DNA may be used for portions of the arms **120, 140** or **160.** For example, duplexes containing **5**-fluorouricil may form M-DNA while duplexes lacking this base may not, so that the composition of nucleic acid strands **1140, 1160** and **1180** may be adapted so that the donor arm **160** and the acceptor arm **140** contain a high proportion of **5**-fluorouricil. In this way, the effect of the modulator **240** on the conductive junction **180** may be made dependent upon the conditions to which element **100** is subjected (dictating whether an arm is in the form of B-DNA or M-DNA). Similarly, nucleic acid binding proteins may be used to modulate conductivity of the arms **120, 140** and **160.**

In alternative embodiments, the electron flow modulator **240** may be capable of absorbing or donating electrons from a conductive medium, while being electrically insulated from the conductive junction **180** by a non-conductive modulator arm **120.** A non-conductive modulator arm **120** may for example be formed, as described above, under conditions wherein a conductive duplex is formed on the donor arm **160** and the acceptor arm **140,** but not on the modulator arm **120.**

In alternative embodiments, the organic circuit element **100** may be constructed to provide different forms of functionality. The electron acceptor **220** may, for example, act as a detectable label for conductivity of the circuit element **100.** For example, the electron acceptor **220** may be a chromophore, which upon accepting an electron, may emit a photon at a different or characteristic wavelength, so that the emitted photon may be detected.

In alternative embodiments, organic circuit elements may include a plurality of donor arms, acceptor arms, or modulator arms.

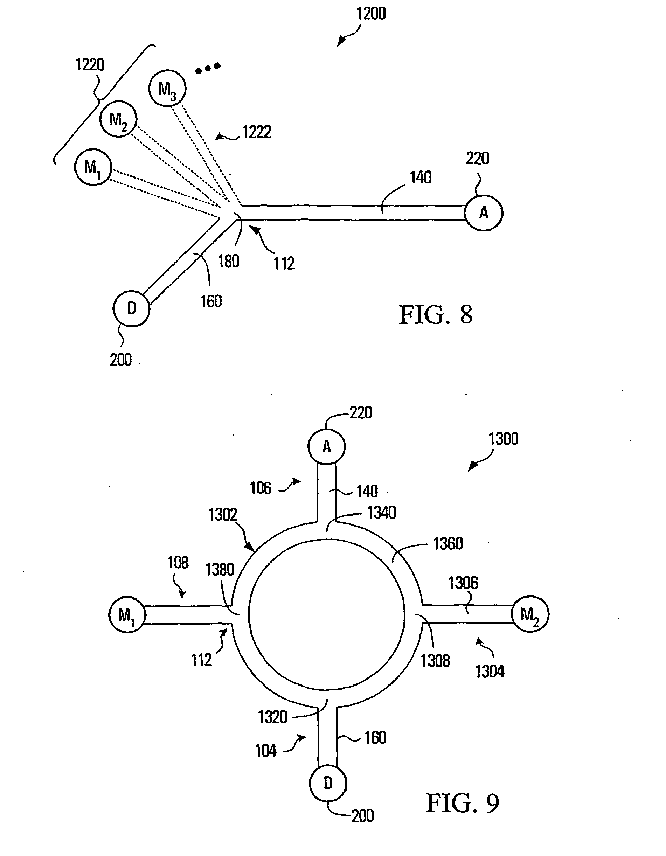

For example, referring to Figure **8,** an organic circuit element according to a fifth embodiment of the invention is shown generally at **1200.** In this embodiment, the plurality **102** of members includes a plurality **1220** of regulator members, formed in a configuration in which the plurality **1220** of regulator members intersects the plurality **102** of members to define the at least one electric field regulation junction **112.** More particularly, in this embodiment, the organic circuit element **1200** includes the donor arm **160** and the acceptor arm **140,** both of which intersect at a conductive junction **180** with a plurality **1222** of electron flow modulator arms, which in turn are connected to respective electron flow modulators. The strands of oligonucleotides used to form the organic circuit element **1200** may be chosen in the appropriate sequences so that they can only anneal in the desired configuration, each strand of oligonucleotides forming the duplexes which make up the modulator arms **1222,** the donor arm strand **1160** and the acceptor arm strand **1140** typically being aligned anti-parallel. Advantageously, separate electron flow modulators M₁, M₂, M₃, ... may be used which are each separately responsive to a different condition or signal, such as a particular wavelength of light. In this way, the organic circuit element **1200** may be used as a detector to detect a particular signal, such as a signal or condition inside biological systems.

Referring to Figure **9,** an organic circuit element according to a sixth embodiment of the invention is shown generally at **1300.** In this embodiment, the plurality **102** of members includes a common member **1302,** which in this embodiment includes a circular DNA portion **1360.** In the present embodiment, the donor member **104,** the acceptor member **106** and the regulator member **108** intersect the common member **1302** at first, second and third locations (or junctions) **1320, 1340** and **1380** respectively, the third location **1380** defining the electric field regulation junction **112.** Thus, in this embodiment, the donor arm **160** and the acceptor arm **140** are connected at separate locations or junctions **1320** and **1340** respectively to the circular DNA portion **1360**. Also in this embodiment, a second regulator member **1304,** which in this embodiment includes a second modulator arm **1306**, intersects the common member **1302** at a fourth location **1308** defining a second electric field regulation junction. Thus, in this embodiment the organic circuit element **1300** includes multiple junctions at the locations **1380** and **1308** connecting to multiple respective electron flow modulators M₁ and M₂ which may be the same or different. Thus, in this embodiment the at least one electric field regulation junction includes at least two electric field regulation junctions (at the locations **1308** and **1380**) in electrical communication with at least two respective electric field regulators, and regulation or modulation may be achieved by selecting one of a plurality of states of at least one of the two electric field regulators, each of the states corresponding to a respective electrostatic potential at the electric field regulation junction corresponding to the at least one of the two regulators.

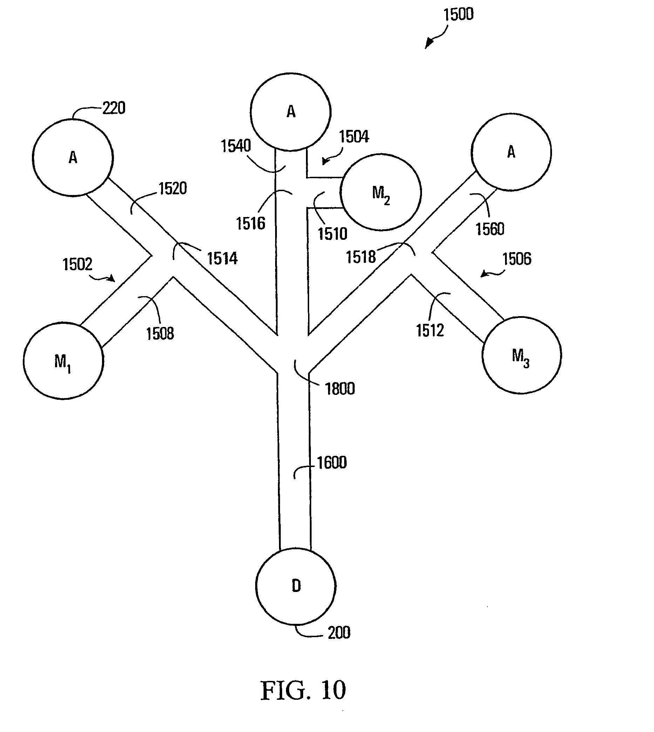

An organic circuit element according to a seventh embodiment is shown generally at **1500** in Figure **10.** In this embodiment, the at least one regulator member includes a plurality of regulator members, which intersect other respective members of the plurality **102** of members to define a plurality of respective electric field regulation junctions. In this embodiment, each such regulator member intersects with one of the donor member and the acceptor member to define the electric field regulation junction, rather than intersecting with both the donor member and the acceptor member. More particularly, in this embodiment the organic circuit element **1500** includes first, second and third regulator members **1502, 1504** and **1506,** which in turn include respective modulator arms **1508, 1510** and **1512.** In this embodiment, the modulator arms **1508, 1510** and **1512** intersect with respective acceptor arms **1520, 1540** and **1560** to define respective electric field regulation junctions **1514, 1516** and **1518.** The acceptor arms **1520, 1540** and **1560** intersect each other and intersect an electron donor arm **160** to define a conductive junction **1800.** Thus, the organic circuit element **1500** includes multiple electron flow modulators M₁, M₂, M₃ and electron flow-modulator arms **1508, 1510** and **1512** connected to each acceptor arm of the plurality of acceptor arms. It will be appreciated that variations in electrostatic potential at any of the electric field regulation junctions **1514, 1516** and **1518** will also result in electrostatic potential variations at the conductive junction **1800,** which therefore also effectively acts as an electric field regulation junction.

It is noted that organic circuit elements according to some embodiments of the invention may be used to detect the presence of a particular nucleic acid homologous to a single stranded component of an electron modulator arm. Nucleic acid in a sample may for example be labeled to include an electron flow modulator, such as fluorescein, and the sample may be mixed with organic circuit elements having single stranded electron modulator arms, so that if a nucleic acid is present in the sample that is homologous to the single stranded modulator arm, it will hybridize. Following hybridization, conditions may be adjusted to favor the formation of a conductive duplex in the electron modulator arm, to bring the label attached to the sample nucleic acid into electrical communication with the remainder of the organic circuit element. The presence of the conductive electron modulator arm in the circuit element may be detected by a change in the conductivity between the electron door arm and the electron acceptor arm.

Although various embodiments of the invention are disclosed herein, many adaptations and modifications may be made within the scope of the invention in accordance with the common general knowledge of those skilled in this art. Such modifications include the substitution of known equivalents for any aspect of the invention in order to achieve the same result in substantially the same way. Numeric ranges are inclusive of the numbers defining the range. In the specification, the word "comprising" is used as an open-ended term, substantially equivalent to the phrase "including, but not limited to", and the word "comprises" has a corresponding meaning. Citation of references herein shall not be construed as an admission that such references are prior art to the present invention. All publications, including but not limited to patents and patent applications, cited in this specification are incorporated herein by reference as if each individual publication were specifically and individually indicated to be incorporated by reference herein and as though fully set forth herein.

### EXAMPLE

Abstract: In this example, an M-DNA complex was formed between duplex DNA and divalent metal ions at approximately pH 8.5. 30 base pair linear duplexes were prepared with fluorescein attached to on end, and anthraquinone at the other. Quenching of the fluorescence emission from fluorescein by anthraquinone was under conditions corresponding to M-DNA, but not for B-DNA. The quenching, which is ascribed to an electron transfer process, was blocked by chemical reduction using NaBH₄ of anthraquinone to the dihydroanthraquinone which is not an electron acceptor. Upon the reoxidation of the dihydroquinone by exposure to oxygen the quenching was restored. Quenching of fluorescein fluorescence was also observed in a 90 base pair Y-branched duplex in which rhodamine or anthraquinone were attached to one of two of the remaining arms. Thus the electron transfer process is not impeded by the presence of a junction in the duplex, contrary to results previously reported for B-DNA samples. Again the fluorescein fluorescence could be modulated by reduction of the anthraquinone group in the Y-branched duplexes, mimicking a simple chemical switch. Therefore M-DNA may have extraordinary potential for the development of nanoelectronic devices.

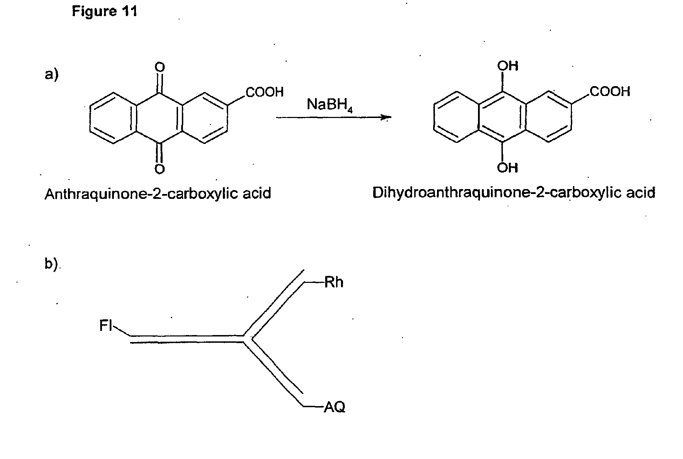

Detailed Description: Dyes such as anthraquinone(15,26-28) (and derivatives thereof) have been extensively used to probe charge transfer processes occurring in DNA, with the dye (in its excited state) serving as an electron acceptor from guanine; however, they have not been studied in donor/acceptor combinations separated by a DNA duplex. These dyes, and related biologically important quinones, are of particular interest in light of their intimate involvement in electron transport and in the photosynthetic pathway, and are being studied in the development of photosynthetic mimics(29). Here we report the results of a study of fluorescence quenching of fluorescein by anthraquinone in M-DNA using 30-base pair linear duplexes. Anthraquinone in observed to quench the fluorescence of fluorescein under M-DNA conditions for both structures; however, upon reduction of the anthraquinone dye to the hydroquinone (Figure 11a), quenching is significantly reduced. In effect the electron transfer process is blocked by chemical reduction of the acceptor group.

Branched duplexes can be constructed from 3 distinct single strands having appropriate complementary sections, as shown in Figure 11 b. Previous studies have shown the branched duplexes to be a Y-shaped molecule with three arms in an essentially planar geometry with equal angles between each arm(30,31). The addition of metal cations does not result in helix-helix stacking observed in 4-way junctions, rather the 3-way junction remains in an extended y-shaped conformation (30,31). Such junctions, in B-DNA, typically results in less efficient electron transfer(32-34). Here, efficient electron transfer is observed to occur between fluorescein and the acceptors anthraquinone and/or rhodamine, through a Y-branched junction.

Materials and Methods: Fluorescence measurements were initially carried out using a 30 base pair sequence, in order to evaluate the efficiency of anthraquinone (AQ) as a quencher for fluorescein. Three 60 base single-strands were used to form a duplex, of a 90 base pair overall size, containing a Y-junction (see below), allowing for a number of donor-acceptor combinations. The sequences used in this study are given in Table 1. The y-junctions were prepared by incubating the three single strands in the dark, in 10 mM Tris-HCl (pH 8) and 10 mM NaCl at 65°C for two hours, followed by slow cooling to room temperature(31). Agarose gel (4%) electrophoresis of the Y-branched duplexes demonstrated the formation of a single species with a mobility corresponding to 110-124 base pairs (data not shown). This is in agreement with previous reports, and suggests that the Y-shaped structure retards the migration of the duplex. (31)

Donor strands were labeled in the 5' position with 5-carboxyfluorescein. (FI) and the complementary (acceptor) strands were labeled in the 5' position with 2-anthraquinonecarboxylic acid (Aldrich) or 5(6)-carboxytetramethyrhodamine (Rh). The dye molecules were covalently attached using a standard 6-aminohexyl linker. Where necessary, carboxylic acid derivatives were converted to activated esters prior to attachment. Sequences were obtained from either Calgary Regional DNA Synthesis Facility or from the DNA/Peptide Synthesis Lab at the National Research Council Plant Biotechnology Institute (Saskatoon). Fluorescence measurements were carried out using a Hitachi model F2500 fluorometer at DNA concentrations of 1.5 µM (in bases), unless otherwise specified, in 20 mM Tris-HCl buffer at either pH 7.5 for B-DNA conditions or pH 8.5 for M-DNA conditions. Fluorescein was excited at 490 nm, and the emission spectra recorded from 500-800 nm. Conversion to M-DNA was accomplished by the addition of 20 mM ZnCl₂ stock solution, to a final concentration of 0.2 mM(24).

The reduction of AQ was carried out using a 0.5 mM stock solution of NaBH₄ (made fresh prior to reduction)(35). Briefly, the NaBH₄ stock solution was added to a solution of 150 µM (in bases) AQ-labeled single stranded DNA, and incubated at room temperature for 2 hours. The reduced strand was then hybridized with the complementary fluorescein-labeled single strand to produce the fluorescein / dihydroanthraquinone labeled duplex. As a control experiment, both the fluorescein labeled single strand, as well as a fluorescein/anthraquinone duplex were also subjected to the same reduction process. Where necessary, samples were de-oxygenated by bubbling with nitrogen gas for a minimum of 30 minutes.

In order to ensure that the above procedure resulted in a reduction of the AQ group, the same procedure was carried out using 34 µM 2-anthraquinone N-hydroxysuccinimidyl ester (AQ-NHS) in pH 8.0 10 mM Tris-HCl, 10 mM NaCl buffer. This solution was degassed by bubbling with nitrogen for ½ hour prior to reduction. The reduction was carried out using 0.5 M NaBH₄, to a final concentration of 1.9 mM. UV-vis absorbance spectra were measured before and after the reduction procedure with a Gilford 600 spectrometer. Finally, in order to determine whether or not the reduction procedure results in damage to the strands themselves, polyacrylamide gel electrophoresis (PAGE) analysis of the reduced FI-30-AQ duplexes was carried out using a 20% polyacrylamide gel.

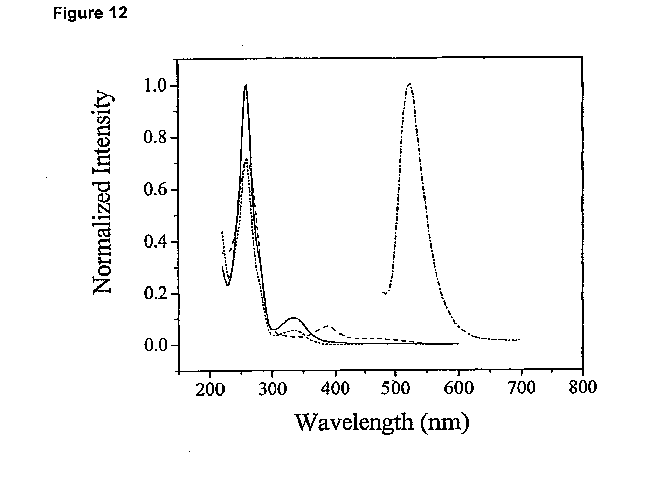

Results and Discussion: The absorbance spectra of AQ-NHS (in deoxygenated buffer solution) prior to and following reduction, and upon reoxidation are shown in Figure 12. Upon addition of 3 mM NaBH₄ the characteristic absorption at 335 nm disappears with a new absorption at 388 nm, which corresponds to the hydroquinone(35). As anticipated, the hydroquinone could be reoxidized to the anthraquinone upon exposure to oxygen(36). Unfortunately, due to the high concentration of DNA required, it was not possible to carry out a similar experiment using the AQ-labeled DNA. However it is expected that the reduction will not be impacted by attachment to DNA.

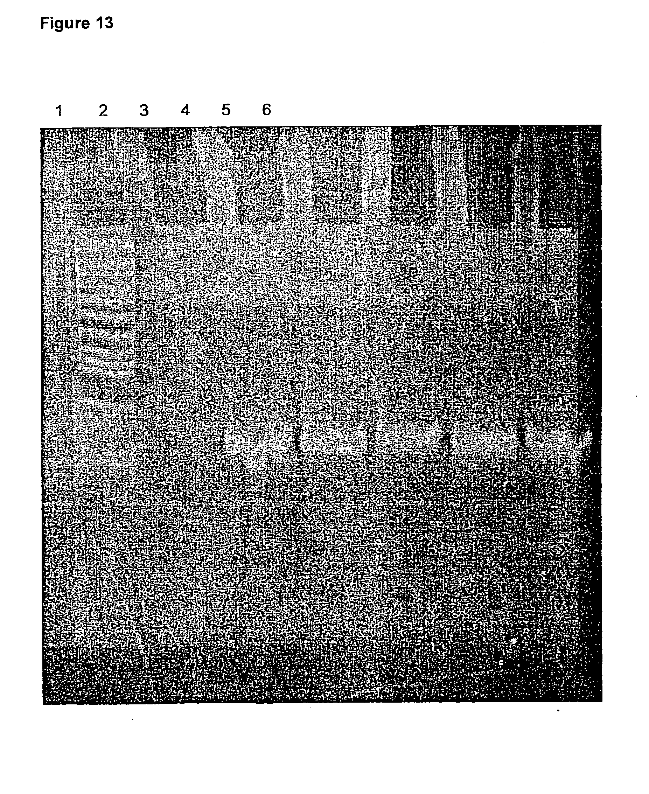

A number of control experiments were carried out in order to ensure that the addition of NaBH₄ did not result in either damage to the DNA. Figure 13 illustrates the results of PAGE analysis of both the reduced and native FI-30-Aq duplexes. In all cases the migration of the FI-30-Aq duplex compares well with the corresponding DNA markers. By comparing lane 5 (0 mM NaBH₄) to lanes 3 and 4 (2.5 and 25 mM NaBH₄, respectively) of the gel it can be seen that the reduction procedure does not result in any damage to the labeled single strand; specifically, the untreated and treated duplexes migrate to the same level. Further, comparing lanes 3 and 6, it can be seen that reduction of the anthraquinone label following hybridization (lane 6) as opposed to prior to hybridization (lane 3) also does not result in any damage to the duplex itself.

Similarly, an ethidium bromide fluorescence assay showed binding of ethidium to the treated duplex at the same level as untreated DNA. Any damage to the duplex would result in a loss of fluorescence due to decreased binding, which was not observed. Finally, fluorescence excitation and emission spectra for fluorescein and rhodamine remain unchanged upon treatment with NaBH₄, indicating that the addition of NaBH₄ did not result in their reduction.

The attachment of the anthraquinone group to a fluorescein-labeled 30-mer results in significant quenching of the fluorescein fluorescence upon formation of M-DNA, as shown in Table 2. Under the standard conditions used to form M-DNA(24), namely 0.2 mM Zn²⁺ concentration, rhodamine and anthraquinone quench the fluorescence from fluorescein to 86% and 59%, respectively. As observed previously(24,37) the degree of quenching depends on the nature of the acceptor and, as will be seen below, the length of the duplex. Due to the lack of spectral overlap (see Figure 12) between fluorescein and anthraquinone, resonance energy transfer is not a possible mechanism for the de-activation of excited state fluorescein.(38) Further, in considering the redox potentials of fluorescein as an electron donor (E^{o}_{Ox} = 0.96 V(39), ΔE_{0.0} = 2.46 eV) and anthraquinone as an electron acceptor (E^{o}_{Red} = -0.94 V)(40), the Rehm-Weller equation(41) predicts an exergonically favorable electron transfer process with ΔG = -0.56 eV. Indeed, photo-induced electron transfer from fluorescein to anthraquinone (in molecular dyads) has previously been observed using both fluorescence quenching and ESR methods(42). In this dyad, anthraquinone was observed to quench the fluorescence from fluorescein by 98%, attributed to an electron transfer process with k_{ET} = 4 × 10⁹ s⁻¹. Therefore, chemical reduction of anthraquinone in the M-DNA systems should result in a decrease in the fluorescence quenching of fluorescein, as it will no longer be able to accept an electron transferred from fluorescein.

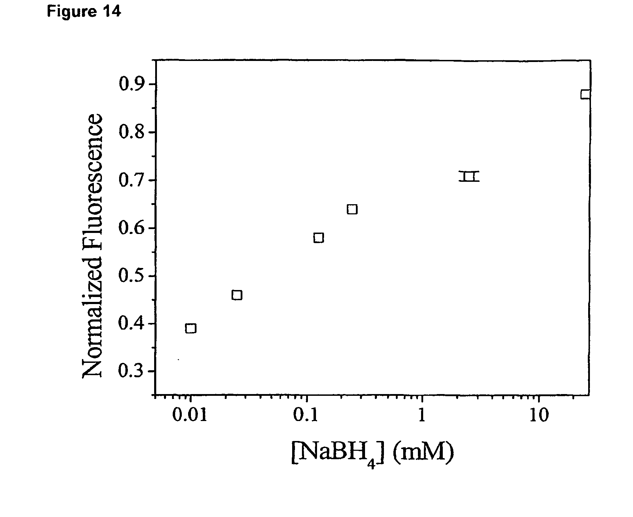

Figure 14 shows that this is indeed the case, with the normalized intensity from fluorescein increasing, with increasing borohydride concentration. As a control, duplexes labeled with fluorescein (FI-30), and with both fluorescein and rhodamine (FI-30-Rh) were treated in the same manner as the FI-30-AQ duplex. As shown in Table 2, for the FI-30 duplex, no effect was observed, and the emission from fluorescein was unchanged. Similarly, the observed quenching for the FI-30-Rh duplex was also found to be unchanged by the reduction procedure. The results given in Table 2 show that the reduction of AQ by 2.5 mM NaBH₄ results in an increase in the normalized fluorescence from 0.41 ± 0.04 for unreduced FI-30-AQ to 0.71 ± 0.01 for reduced FI-30-AQ. As was observed for AQ-NHS in buffer, the effect of NaBH₄ on the FI-30-AQ duplex is reversible with oxygen. Upon deliberate exposure of the reduced sample to air (i.e. oxygen) the normalized fluorescence decreased to 0.42 ± 0.03.

In order to be able to design more complicated pseudo-electronic devices from DNA, it is necessary to not only synthesize branched structures, but also to demonstrate electron transfer through the resulting junctions. A 90 base pair Y-branched three-way DNA junction was prepared from three complementary 60 base oligonucleotides such that each arm of the junction is a 30 base pair duplex. Table 3 gives the normalized fluorescence observed for various donor-acceptor combinations for the Y-branched DNA duplexes under M-DNA conditions. The combination of one donor with two acceptors results in the greatest amount of quenching, regardless of acceptor combination, i.e., two rhodamine groups (58%) or one rhodamine and one anthraquinone (63%), and is comparable to that observed for a 54 base pair fluorescein/rhodamine labeled unbranched duplex. (57%(24)). This implies that the quenching mechanism, specifically electron transfer, is in no way hindered by a branched junction in M-DNA. In contrast charge transfer through unstacked bases or through a branch or junction in B-DNA is either hindered(32-34), or does not occur(43).

Less quenching was observed for the case of a single acceptor (on average 36%), which combined with the results obtained for two acceptor molecules has two important implications. The first is that in considering the case of two acceptor molecule, there is an equal probability for electron transfer to either acceptor arm. However, the second result, namely the observed quenching for a single acceptor being less than half that for two acceptors, indicates that for the case of one acceptor molecule there is an increased probability for transfer to the acceptor-labeled arm. If it were the case that the probability of transfer to the unlabeled arm was zero, one would expect the observed quenching to again be similar to that observed for the double labeled 54 base pair unbranched duplex. However, if there is an equal probability of electron transfer to the unlabeled arm this begs the question; what is the fate of the electron once it reaches the unlabeled arm? Or is it the case that for a single acceptor molecule is there is a reduced probability for fluorescein to donate an electron as a result of quantum effects not yet considered? Regardless of the answer to these questions, the results indicate an enormous potential for the application of these systems to the design of molecular scale electronic devices.

Anthraquinone quenches fluorescein by 23% in the Y-branched duplexes, compared to rhodamine which quenches, on average, 38% (independent of which strand has the donor and acceptor chromaphore). Therefore, as for the 30 base pair duplexes, in the Y-branched DNA duplexes anthraquinone is not as efficient an acceptor as rhodamine. Nevertheless the addition of NaBH₄ again results in an increase in fluorescence emission from fluorescein, i.e., the quenching mechanism is again blocked, with the normalized emission increasing to nearly 1. For the double-labeled systems the addition of NaBH₄ results in a decrease in quenching from 63% to 38%. This provides a means to modulate the fluorescence from the Y-branched duplex, in effect mimicking the classical transistor, which consists of a source, a gate, and a drain. The source and drain electrodes are separated by a semiconducting channel, across which the potential is controlled by the gate voltage. In the Y-branched duplexes, the fluorescein-labeled arm acts as the source, and the rhodamine-labeled arm can be thought of as the drain with the anthraquinone-labeled arm acting as the gate. The state of the anthraquinone group, i.e. reduced or unreduced, provides the means of modulating the resulting signal, in this case the emission intensity from fluorescein.

**Table 1: 30- and 60-base pair sequences.**

| ID | Sequence |
|---|---|
| FI-30 | 5'-GTG GCT AAC TAC GCA TTC CAC GAC CAA ATG-3' |
| AQ-30 / Rh-30 | 5'-CAT TTG GTC GTG GAA TGC GTA GTT AGC CAC-3' |
| X | 5'-GCC TAG CAT GGA CTA GCG AAT TCC CGC TCT TCT CAA CTC TAG ACT CGA GGT TCC TGT CGC-3' |
| Y | 5'-GCG TAG CCT ACG GAC TGA AGC TTA GCA GCG AGA GCG GGA ATT CGC TAG TCC ATG CTA GGC-3' |
| Z | 5'-GCG ACA GGA ACC TCG AGT CTA GAG TTG AGA CGC TGC TAA GCT TCA GTC CGT AGG CTA CGC-3' |

**Table 2: Normalized fluorescence (λ_{Em} = 520 nm) for various donor-acceptor combinations for the 30 base pair DNA duplexes; [Zn²⁺] = 0.2 mM, pH 8.5, 20 mM Tris-HCl buffer.**

| Duplex | [NaBH₄] (mM) | Normalized Fluorescence |
|---|---|---|
| FI-30 | 0 | 1.00 |
| FI-30 | 2.5 | 1.00 |
| FI-30-Rh | 0 | 0.14 ± 0.03 |
| FI-30-Rh | 2.5 | 0.19 ± 0.03 |
| FI-30-AQ | 0 | 0.41 ± 0.04 |
| FI-30-AQ | 2.5 | 0.71 ± 0.01 |
| FI-30-Aq + | 2.5 | 0.42 ± 0.03 |
| O₂ | | |

**Table 3: Normalized fluorescence (λ_{Em} = 520 nm) for various donor-acceptor combinations for the Y-branched DNA junctions; [Zn²⁺] = 0.2 mM, pH 8.5, 20 mM Tris-HCl buffer.**

| X Strand | Y Strand | Z Strand | [NaBH₄] (mM) | Normalized Fluorescence |
|---|---|---|---|---|
| a) | Double labeled | | | |
| Rhodamine | Fluorescein | | 0 | 0.61 ± 0.03 |
| Rhodamine | | Fluorescein | 0 | 0.64 ± 0.04 |
| | Fluorescein | Rhodamine | 0 | 0.62 ± 0.03 |
| | Rhodamine | Fluorescein | 0 | 0.60 ± 0.06 |
| Fluorescein | Rhodamine | | 0 | 0.65 ± 0.03 |
| Fluorescein | | Rhodamine | 0 | 0.62 ± 0.01 |
| Fluorescein | | Rhodamine | 2.5 | 0.66 ± 0.02 |
| Fluorescein | Anthraquinone | | 0 | 0.77 ± 0.01 |
| Fluorescein | Anthraquinone | | 2.5 | 0.92 ± 0.02 |
| | | | | |

| b) | Triple Labeled | | | |
|---|---|---|---|---|
| Rhodamine | Rhodamine | Fluorescein | 0 | 0.42 ± 0.03 |
| Rhodamine | Fluorescein | Rhodamine | 0 | 0.42 ± 0.03 |
| Fluorescein | Rhodamine | Rhodamine | 0 | 0.42 ± 0.03 |
| Fluorescein | Anthraquinone | Rhodamine | 0 | 0.37 ± 0.01 |
| Fluorescein | Anthraquinone | Rhodamine | 2.5 | 0.62 ± 0.02 |

Conclusions: Anthraquinone, covalently attached to DNA, has been shown to be an efficient quencher of the fluorescence from fluorescein in M-DNA systems. Good quenching is observed over distances of 60 base pairs, through a Y-branched junction. Therefore, as has been previously suggested(9,23,24), the M-DNA conformation offers an improved pathway for efficient conduction in DNA, a critical aspect for future development of nanometer-scale electronic devices. The emission intensity from fluorescein was modulated by chemical reduction of the anthraquinone group which was reversible by reoxidation with oxygen, providing a simple chemical switch. Applying these results to the Y-branched junctions containing 1 donor and two acceptors results in a system that optically mimics an electronic transistor. As such these systems are a critical first step in the future development of more complex nanoelectronic devices.

### References:

1. Mao, C., Sun, W., Shen, Z. and Seeman, N. C. (1999) A nanomechanical device based on the B-Z transition of DNA. *Nature,* **397,** 144-146.
2. Yan, H., Zhang, X., Shen, Z. and Seeman, N. C. (2002) A robust DNA mechanical device controlled by hybridization topology. *Nature,* **415**, 62-65.
3. Zhang, X., Yan, H., Shen, Z. and Seeman, N. C. (2002) Paranemic cohesion of topologically-closed DNA molecules. *J. Am. Chem. Soc.,* **124,** 12940-12941.
4. Niemeyer, C. M. and Adler, M. (2002) Nanomechanical devices based on DNA. *Angew. Chem. Int. Ed.,* **41**(20), 3779-3783.
5. Arkin, M. R., Stemp, E. D. A., Holmin, R. E., Barton, J. K., Hormann, A., Olson, E. J. C. and Barbara, P. F. (1996) Rates of DNA-mediated electron transfer between metallointercalators. *Science,* **273**, 475-479.
6. Hall, D. B., Holmlin, R. E. and Branton, J. K. (1996) Oxidative DNA damage through long-range electron transfer. *Nature,* **382**, 731-735.
7. Dandliker, P. J., Holmlin, R. E. and Barton, J. K. (1997) Oxidative thymine dimer repair in the DNA helix. *Science,* **275,** 1465-1468.
8. Porath, D., Bezryadin, A., de Vries, S. and Dekker, C. (2000) Direct measurement of electrical transport through DNA molecules. *Nature,* **403**, 635-638.
9. Rakitin, A., Aich, P., Papadopoulos, C., Kobzar, Y., Vedeneev, A. S., Lee, J. S. and Xu, J. M. (2001) Metallic conduction through engineered DNA: DNA nanoelectronic building blocks. *Phys. Rev. Lett.,* **86**(16), 3670-3673.
10. Storm, A. J., van Noort, J., de Vries, S. and Dekker, C. (2001) Insulating behavior for DNA molecules between nanoelectrodes at the 100 nm length scale. *Appl. Phys. Lett.,* **79,** 3881-3883.
11. Gomez-Navarro, C., Moreno-Herrero, F., de Pablo, P. J., Gomez-Herrero, J. and Baro, A. M. (2002) Contactless experiments on individual DNA molecules show no evidence for molecular wire behavior. *Proc. Nat. Acad. Sci. (USA),* **99**(13), 8484-8487.
12. Braun, E., Eichen, Y., Sivan, U. and Ben-Yoseph, G. (1998) DNA-templated assembly and electrode attachment of a conducting silver wire. *Nature,* **391**, 775-778.
13. Hurley, D. J. and Tor, Y. (2002) Donor/Acceptor interactions in systematically modified Ru^{II}-Os^{II} oligonucleotides. *J. Am. Chem. Soc.,* **124**, 13231-13241.
14. O'Neill, M. A. and Barton, J. K. (2002) 2-Aminopurine: A probe of structural dynamic and charge transfer in DNA and DNA:RNA hybrids. *J. Am. Chem. Soc.,* **124,** 13053-13066.
15. Henderson, P. T., Jones, D., Hampikian, G., Kan, Y. and Schuster, G. B. (1999) Long-distance charge transport in duplex DNA: The phonon assisted polaron-like hopping mechanism. *Proc. Nat. Acad. Sci. (USA),* **96**, 8353-8358.
16. Jortner, J., Bixon, M., Langenbacher, T. and Michel-Beyerle, M. E. (1998) Charge transfer and transport in DNA. *Proc. Nat. Acad. Sci. (USA)*, **95,** 12759-12765.
17. Bixon, M. and Jortner, J. (2001) Charge transport in DNA via thermally induced hopping. *J. Am. Chem. Soc.,* **123,** 12556-12567.
18. Bixon, M., Giese, B., Wessely, S., Langenbacher, T., Michel-Beyerle, M. E. and Jortner, J. (1999) Long-range charge hopping in DNA. *Proc. Nat. Acad. Sci. (USA),* **96**(21), 11713-11716.
19. Meggers, E., Michel-Beyerle, M. E. and Giese, B. (1998) Sequence dependent long range hole transport in DNA. J. *Am. Chem. Soc.,* **120**, 12950-12955.
20. Giese, B., Amaudrut, J., Kohler, A.-K., Spormann, M. and Wessely, S. (2001) Direct observation of hole transfer between adenine bases and by tunnelling. *Nature,* **412**(318-320).
21. Hess, S., Gotz, M., Davis, W. B. and Michel-Beyerle, M.-E. (2001) On the apparently anomalous distance dependence of charge-transfer rates in 9-amino-6-chloro-2-methoxyacridine-modified DNA. *J. Am. Chem. Soc.,* **123,** 10046-10055.
22. Pascaly, M., Yoo, J. and Barton, J., K. (2002) DNA mediated charge transport: Characteristics of a DNA radial localised at an artificial nucleic acid base. *J. Am. Chem. Soc.*, **124**(9083-9092).
23. Aich, P., Labiuk, S., L., Tari, L., W., Delbaere, L., J. T., Roesler, W., J., Falk, K. J., Steer, R. P. and Lee, J. S. (1999) *M*-DNA: A complex between divalent metal ions and DNA which behaves as a molecular Wire. J. *Mol. Biol.,* **294,** 477-485.
24. Aich, P., Skinner, R. J. S., Wettig, S. D., Steer, R. P. and Lee, J. S. (2002) Long range molecular wire behaviour in a metal complex of DNA. *J. Biomol. Struct. Dynamics,* **20, 1-6.**
25. Lee, J. S., Latimer, L., J.P. and Reid, R. S. (1993) A cooperative conformational change in duplex DNA induced by Zn²⁺ and other divalent metal ions. *Biochem. Cell Bio.,* **71**, 162-168.
26. Gasper, S. M. (1997) Intramolecular photoinduced electron transfer to anthraquinones linked to duplex DNA: The effect of gaps and traps on long-range radical cation migration. *J. Am. Chem. Soc.*, **119**, 12762-12771.
27. Ly, D., Kan, Y., Armitage, B. and Schuster, G. B. (1996) Cleavage of DNA by irradiation of substituted anthraquinones: Intercalation promotes electron transfer and efficient raction at GG steps. *J. Am. Chem. Soc.,* **118**(8747-8748).
28. Armitage, B., Yu, C., Devadoss, C. and Schuster, G., B. (1994) Cationic anthraquinone derivatives as catalytic DNA photonucleases: Mechanism for DNA damage and quinone recycling. *J. Am*. *Chem. Soc*., **116**, 9487-9859.
29. Rajesh, C. S., Capitosti, G. J., Cramer, S. J. and Modarelli, D. A. (2001) Photoinduced Electron-Transfer within Free Base and Zinc Porphyrin Containing Poly(Amide) Dendrimers. *J. Phys. Chem. B,* **105**, 10175-10188.
30. Lilley, D. M. J. (2000) Structures of helical junctions in nucleic acids. *Quart. Rev. Biophys.,* **33,** 109-159.
31. Duckett, D. R. and Lilley, D. M. J. (1990) The three-way DNA junction is a Y-shaped molecule in which there is no helix-helix stacking. *EMBO Journal,* **9**, 1659-1664.
32. Fahlman, R. P. and Sen, D. (2002) DNA conformational switches as sensitive electronic sensors of analytes. *J. Am. Chem. Soc.,* **124,** 4610-4616.
33. Giese, B. and Wessely, S. (2000) The Influence of Mismatches on Long-Distance Charge Transport through DNA. *Angew. Chem. Int. Ed.,* **39,** 3490-3491.
34. Kelley, S. O., Holmlin, R. E., Stemp, E. D. A. and K., B. J. (1997) Photoinduced Electron Transfer in Ethidium-Modified DNA Duplexes: Dependence on Distance and Base Stacking. *J. Am. Chem. Soc.,* **117,** 9861-9870.
35. Wightman, R. M., Cockrell, J. R., Murray, R., W., Burnett, J. N. and Jones, S. B. (1976) Protonation kinetics and mechanisms for 1,8-dihydroxyanthraquinone and anthraquinone anion radicals in dimethylformamide solvent. *J. Am. Chem. Soc.,* **98**(9), 2562-2570.
36. Liu, M. D., Patterson, D. H., Jones, C. R. and Leidner, C. R. (1991) Redox and structural properties of quinone functionalized phosphatidylcholine liposomes. *J. Phys. Chem.,* **95**, 1858-1865.
37. Wettig, S. D., Li, C., Long, Y., Kraatz, H.-B. and Lee, J. S. (2002) "21 st century bioanalysis" M-DNA: a self-assembling molecular wire for nanoelectronics and biosensing. *Anal. Sci.,* **Accepted.**
38. Lakowicz, J. R. (1999) Principles of fluorescence spectroscopy, 2 Ed., Kluwer Academic/Plenum Publishers, New York.
39. Loufty, R. O. and Sharp, J. H. (1976) Correlation between photographic properties of dyes and their electrochemical and spectroscopic parameters. *Photographic Science and Engineering,* **20**, 165-174.
40. Chanon, M. and Eberson, L. (1988) Photochemistry of homogeneous and heterogeneous chemical gears involving electron transfer catalysis: Chains, catalysts and sensitization. Relations to electrochemistry, synthetic applications and mechanistic basis for selectivity. In Fox, M. A., and Chanon, M. (eds.), Photoinduced Electron Transfer Part A: Conceptual Basis. Elsevier, New York, pp. 409-597.
41. Fox, M. A. (1990) Photoinduced electron transfer. *Photochem. Photobiol*., **52**(3), 617-627.
42. Zhang, H., Zhou, Y., Zhang, M., Shen, T., Li, Y. and Zhu, D. (2002) A Comparative Study on Photo-Induced Electron Transfer from Fluorescein to Anthraquinone and Injection into Colloidal TiO₂. *J. Colloid Interface Sci.,* **251,** 443-446.
43. Fahlman, R. P., Sharma, R. D. and Sen, D. (2002) The charge conduction properties of DNA Holliday junctions depend critically on the identity of the tethered photooxidant. J. *Am. Chem. Soc.,* **124**, 12477-12485.

### FURTHER REFERENCES

a. Gelbart, W.M., Bruinsma, R.F., Pinkcus, P.A., and Parsegian, V.A. Physics Today **53**, September **2000, 38-44** (**2000**).
b. Porath, D, Bezryadin, A., de Vries, S., and Dekker, C. Nature **403**, **635-638** (**2000**).
c. Lewis, F.D., Wu, T., Zhang, Y., Letsinger, R.L., Greenfield, S.R., and Wasielewski, M.R. Science **277, 673-676** (**1997**).
d. Taubes, G. Science **275, 1420-1421** (**1997**).
e. Aich, P., Labiuk, S.L., Tarl L.W., Delbaere, L.J.T., Roesler, W.J., Faulk, K.J., Steer, R.P., and Lee, J.S. Journal of Molecular Biology **294, 477-485** (**1999**).
f. Lee, J.S., Latimer, L.J.P., and Reid, R.S. Biochem. Cell Biol. **71, 162-168** (**1993**).
g. Braun, E., Eicher, Y., Sivan, U., and Ber-Yoseph, G. Nature **391, 775-778** (**1998**).
h. Lines, M.E., and Glass, A.M. *Principles & Applications of Ferroelectrics & Related Materials* (Clarendon Press, Oxford, **1977**).
i. Sponer, J., Burda, J.V., Leszczynski, J., and Hobza, P.J. Biomol. Struct. Dyn. **17, 61** (**1999**).
j. Seeman, N.C., and Kallenback, N.R. Ann. Rev. Biophys. Biomol. Struct. **23, 53-86** (**1994**).
k. Wang, J., Rivas, G., Jiang, M., and Zhang, X. Langmuir. **15, 6541-6545** (**1999**).
I. Aich and Lee (**1999**) WO **99/31115**

## Claims

1. A method for altering the conductivity of an organic circuit element (100), wherein the organic circuit element comprises:
a) a plurality of members (102), each of which comprises an oligonucleotide duplex, said plurality of members comprising:
i) at least one donor member (104) for receiving conduction electrons from an electron donor (200);
ii) at least one acceptor member (106) for communicating with an electron acceptor (220) to provide a region of attraction for said conduction electrons; and
iii) at least one regulator member (108) intersecting with at least one of said plurality of members (102) to define at least one electric field regulation junction (112), for cooperating with an electric field regulator (114) to regulate an electric field at the junction (112);
**characterized in that** the conductivity of the organic circuit element (100) is altered by reversibly chemically modifying the electron donor (200) or the electron acceptor (220) under conditions that preserve the conductivity of the organic circuit element (100).

2. The method of claim **1** wherein at least one of said members (102) comprises a conductive metal-containing oligonucleotide duplex.

3. The method of claim **1 or 2** wherein said electron donor (200) is in electrical communication with said donor member (104).

4. The method of claim **3** wherein said electron acceptor (220) is in electrical communication with said acceptor member (106).

5. The method of claim **4** wherein said electric field regulator (114) is in electrical communication with said regulator member (708).

6. The method of any one of claims **1-5** wherein said donor member (104), said acceptor member (106) and said regulator member (108) intersect to define said electric field regulation junction (112).

7. The method of any one of claims **1-5** wherein said regulator member (108) intersects with one of said donor member (104) and said acceptor member (106) to define said electric field regulation junction (112).

8. The method of any one of claims **1-7** wherein said conductive metal-containing oligonucleotide duplex comprises a first nucleic acid strand (320) and a second nucleic acid strand (340), said first and said second nucleic acid strands comprising respective pluralities of nitrogen-containing aromatic bases (350, 360) covalently linked by a backbone (380), said nitrogen-containing aromatic bases of said first nucleic acid strand being joined by hydrogen bonding to said nitrogen-containing aromatic bases of said second nucleic acid strand, said nitrogen-containing aromatic bases on said first and said second nucleic acid strands forming hydrogen-bonded base pairs (400) in stacked arrangement along a length of said conductive metal-containing oligonucleotide duplex (300), said hydrogen-bonded base pairs comprising an interchelated metal cation (420) coordinated to a nitrogen atom in one of said nitrogen-containing aromatic bases (350, 360).

9. The method of claim **8** wherein said interchelated metal cation comprises an interchelated divalent metal cation.

10. The method of claim **9** wherein said divalent metal cation is selected from the group consisting of zinc, cobalt and nickel.

11. The method of claim **8, 9, or 10** wherein said first and said second nucleic acid strands comprise deoxyribonucleic acid and said nitrogen-containing aromatic bases are selected from the group consisting of adenine, thymine, guanine and cytosine.

12. The method of any one of claims **1 to 11** wherein said electron donor comprises an electrode operable to donate an electron to said donor member.

13. The method of any one of claims **1 to 12** wherein said electron acceptor comprises an electrode operable to accept an electron from said acceptor member.

14. The method of any one of claims **1 to 11** wherein said electron donor comprises an electron donor molecule capable of donating an electron to said donor member.

15. The method of claim **14** wherein said electron donor molecule comprises a fluorescent molecule.

16. The method of claim **14** wherein said electron donor molecule comprises fluorescein.

17. The method of any one of claims **1 to 16** wherein said electron acceptor comprises an electron acceptor molecule capable of accepting an electron from said acceptor member.

18. The method of claim **17** wherein said electron acceptor molecule comprises a fluorescent molecule.

19. The method of claim **17** wherein said electron acceptor molecule comprises rhodamine.

20. The method of claim **17,** wherein said electron acceptor molecule comprises anthraquinone.

21. The method of claim **20**, wherein the conductivity of the organic circuit element is altered by reversibly chemically reducing the anthraquinone to dihydroanthraquinone.

22. The method of any one of claims **1 to 21** wherein said electric field regulator comprises a regulator chromophore.

23. The method of any one of claims **1 to 21** wherein said electric field regulator comprises a rhodamine.

24. The method of any one of claims **1** to **21** wherein said electric field regulator comprises an electrode.

25. The method of any one of claims **1 to 24** wherein said electric field regulator comprises a plurality of states, each state of said plurality of states being selectable to produce a respective electrostatic potential at said electric field regulation junction.

26. The method of claim **25** wherein said states are selectable in response to an applied external potential.

27. The method of any one of claims **1 to 26** wherein the organic circuit element is provided in a conductive medium that supplies conduction electrons to said electron donor and receives conduction electrons from said electron acceptor.

28. The method of claim **27** wherein said conductive medium is operable to donate electrons to said electron donor, and is operable to accept electrons from said electron acceptor to provide a closed circuitway for electrons to flow from said electron donor, through said donor member, through said electric field regulation junction, through said acceptor member, through said electron acceptor, and back to said electron donor.

29. The method of claim **27 or 28** wherein said conductive medium comprises an aqueous solution.

30. A method of altering the conductivity of an electrical conductor, wherein:
the electrical conductor comprises an electron source electrically coupled to a conductive metal-containing nucleic acid duplex, the conductive metal-containing nucleic acid duplex comprising a first strand of nucleic acid and a second strand of nucleic acid, the first and the second nucleic acid strands comprising a plurality of nitrogen-containing aromatic bases covalently linked by a backbone, the nitrogen-containing aromatic bases of the first nucleic acid strand being joined by hydrogen bonding to the nitrogen-containing aromatic bases of the second nucleic acid strand, the nitrogen-containing aromatic bases on the first and the second nucleic acid strands forming hydrogen-bonded base pairs in stacked arrangement along the length of the conductive metal-containing nucleic acid duplex, the hydrogen-bonded base pairs comprising an interchelated divalent metal cation coordinated to a nitrogen atom in one of the nitrogen-containing aromatic bases, to form the electrical conductor, further comprising an electron sink electrically coupled to the conductive metal-containing nucleic acid duplex, wherein the electron source is an electron donor molecule capable of donating an electron to the conductive metal-containing nucleic acid duplex, and the electron sink is an electron acceptor molecule capable of accepting an electron from the conductive metal-containing nucleic acid duplex;
**characterized in that** the conductivity of the electrical conductor is altered by reversibly chemically modifying the electron donor or the electron acceptor under conditions that preserve the conductivity of the electrical conductor.

31. The method of claim **30** wherein said divalent metal cation is selected from the group consisting of zinc, cobalt and nickel.

32. The method of claim **30 or 31** wherein said electron donor molecule comprises a fluorescent molecule.

33. The method of claim **30 or 31** wherein said electron donor molecule comprises fluorescein.

34. The method of any one of claims **30** to **33** wherein said electron acceptor molecule comprises a fluorescent molecule.

35. The method of any one of claims **30 to 33** wherein said electron acceptor molecule comprises rhodamine.

36. The method of any one of claims **30 to 33,** wherein said electron acceptor molecule comprises anthraquinone.

37. The method of claim **36,** wherein the conductivity of the electrical conductor is altered by reversibly chemically reducing the anthraquinone to dihydroanthraquinone.

## Patentansprüche

1. Verfahren zum Ändern der Leitfähigkeit eines organischen Schaltkreiselements (100), wobei das organische Schaltkreiselement aufweist:
a) eine Mehrzahl von Gliedern (102), von welchem jedes einen Oligonucleotidduplex aufweist, wobei die Mehrzahl von Gliedern aufweist:
i) wenigstens ein Donatorglied (104) zum Empfangen von Leitungselektronen von einem Elektronendonator (200);
ii) wenigstens eine Akzeptorglied (106) zum Kommunizieren mit einem Elektronenakzeptor (220) um eine Anziehungsregion für die genannten Leitungselektronen zu schaffen; und
iii) wenigstens ein Regulatorglied (108) zum Überkreuzen mit wenigstens einem der genannten Mehrzahl von Gliedern (102) um wenigstens eine Regelungsverbindung (112) für das elektrische Feld zu definieren, um mit einem Regulator (114) für das elektrische Feld zusammenzuarbeiten, um eine elektrisches Feld an der Verbindung (112) zu regeln;
**dadurch gekennzeichnet, dass** die Leitfähigkeit des organischen Schaltkreiselements (100) durch reversibles chemisches Modifizieren des Elektronendonators (200) oder des Elektronenakzeptors (220) unter Bedingungen geändert wird, welche die Leitfähigkeit des organischen Schaltkreiselements (100) bewahren.

2. Verfahren nach Anspruch 1, wobei wenigstens eines der genannten Glieder (102) einen leitenden Metall enthaltenden Oligonucleotidduplex aufweist.

3. Verfahren nach Anspruch 1 oder 2, wobei der genannte Elektronendonator (200) in elektrischer Verbindung mit dem genannten Donatorglied (104) steht.

4. Verfahren nach Anspruch 3, wobei der genannte Elektronenakzeptor (220) in elektrischer Verbindung mit dem genannten Akzeptorglied (106) steht.

5. Verfahren nach Anspruch 4, wobei der genannte Regulator (104) für das elektrische Feld in elektrischer Verbindung mit dem genannten Regulatorglied (108) steht.

6. Verfahren nach einem der Ansprüche 1 bis 5, wobei sich das genannte Donatorglied (104), das genannte Akzeptorglied (106) und das genannte Regulatorglied (108) einander kreuzen um die genannte Regelungsverbindung (112) für das elektrische Feld zu definieren.

7. Verfahren nach einem der Ansprüche 1 bis 5, wobei sich das genannte Regulatorglied (108) mit einem von Donatorglied (104) oder Akzeptorglied (106) kreuzt, um die genannte Regulierungsverbindung (112) für das elektrische Feld zu definieren.

8. Verfahren nach einem der Ansprüche 1 bis 7, wobei der genannte leitende Metall enthaltende Oligonucleotidduplex einen ersten Nucleinsäurestrang (320) und einen zweiten Nucleinsäurestrang (340) aufweist; wobei die genannten ersten und zweiten Nucleinsäurestränge entsprechende Vielzahlen von Stickstoff enthaltenden aromatischen Basen (350, 360) aufweisen, die kovalent durch eine Hauptkette (380) verbunden sind, wobei die genannten Stickstoff enthaltenden aromatischen Basen des genannten ersten Nucleinsäurestranges über Wasserstoffbindungen an die genannten Stickstoff enthaltenden aromatischen Basen des genannten zweiten Nucleinsäurestrangs gebunden sind, wobei die genannten Stickstoff enthaltenden aromatischen Basen am ersten und am zweiten Nucleinsäurestrang Wasserstoff gebundene Basenpaare (400) in gestapelter Anordnung längs des genannten leitenden Metall enthaltenden Oligonucleotidduplex (300) bilden; wobei die genannten Wasserstoff gebundenen Basenpaare ein interchelatiertes Metallkation (420) aufweisen, das mit einem Stickstoffatom in einer der genannten Stickstoff enthaltenden aromatischen Basen (350, 360) koordiniert ist.

9. Verfahren nach Anspruch 8, wobei das genannte interchelatierende Metallkation ein interchelatierendes divalentes Metallkation aufweist.

10. Verfahren nach Anspruch 9, wobei das genannte divalente Metallkation aus der Gruppe bestehend aus Zink, Kobalt und Nickel ausgewählt ist.

11. Verfahren nach Anspruch 8, 9 oder 10, wobei die genannten ersten und zweiten Nucleinsäurestränge Desoxyribonucleinsäure aufweisen und die genannten Stickstoff enthaltenden aromatischen Basen aus der Gruppe bestehend aus Adenin, Thymin, Guanin und Cytosin ausgewählt sind.

12. Verfahren nach einem der Ansprüche 1 bis 11, wobei der genannte Elektronendonator eine Elektrode aufweist, die zur Abgabe eines Elektrons an das genannte Donatorglied wirksam ist.

13. Verfahren nach einem der Ansprüche 1 bis 12, wobei der genannte Elektronenakzeptor eine Elektrode aufweist, die zur Annahme eines Elektrons von dem genannten Akzeptorglied wirksam ist.

14. Verfahren nach einem der Ansprüche 1 bis 11, wobei der genannte Elektronendonator ein Elektronen spendendes Molekül aufweist, das zum Abgeben eines Elektrons an das genannte Donatorglied imstande ist.

15. Verfahren nach Anspruch 14, wobei das genannte Elektronen spendende Molekül ein fluoreszierendes Molekül aufweist.

16. Verfahren nach Anspruch 14, wobei das genannte Elektronen spendende Molekül Fluorescein aufweist.

17. Verfahren nach einem der Ansprüche 1 bis 16, wobei der genannte Elektronenakzeptor ein Elektronen annehmendes Molekül aufweist, das zum Annehmen eines Elektrons von dem genannten Akzeptormolekül imstande ist.

18. Verfahren nach Anspruch 17, wobei das genannte Elektronen annehmende Molekül ein fluoreszierendes Molekül aufweist.

19. Verfahren nach Anspruch 17, wobei das genannte Elektronen annehmende Molekül Rhodamin aufweist.

20. Verfahren nach Anspruch 17, wobei das genannte Elektronen annehmende Molekül Anthrachinon aufweist.

21. Verfahren nach Anspruch 20, wobei die Leitfähigkeit des organischen Schaltkreiselements durch reversibles chemisches Reduzieren des Anthrachinons zu Dihydroanthrachinon geändert wird.

22. Verfahren nach einem der Ansprüche 1 bis 21, wobei der genannte Regulator für das elektrische Feld ein Regulatorchromophor aufweist.

23. Verfahren nach einem der Ansprüche 1 bis 21, wobei der genannte Regulator für das elektrische Feld ein Rhodamin aufweist.

24. Verfahren nach einem der Ansprüche 1 bis 21, wobei der genannte Regulator für das elektrische Feld eine Elektrode aufweist.

25. Verfahren nach einem der Ansprüche 1 bis 24, wobei der genannte Regulator für das elektrische Feld eine Vielzahl von Stati aufweist, wobei jeder Status der Vielzahl von Stati auswählbar ist, um ein entsprechendes elektrostatisches Potential an der Regelungsverbindung für das elektrische Feld zu erzeugen.

26. Verfahren nach Anspruch 25, wobei die genannten Stati als Reaktion auf ein angelegtes externes Potential auswählbar sind.

27. Verfahren nach einem der Ansprüche 1 bis 26, wobei das organische Schaltkreiselement in einem leitfähigen Medium vorgesehen ist, welches Leitungselektronen an den genannten Elektronendonator abgibt und Leitungslelektronen von dem genannten Elektronenakzeptor empfängt.

28. Verfahren nach Anspruch 27, wobei das genannte leitfähige Medium wirksam ist, Elektronen an den genannten Elektronendonator abzugeben, und wirksam ist, Elektronen von dem genannten Elektronenakzeptor zu empfangen, um einen geschlossenen Kreislauf für die Elektronen zu bilden, damit die Elektronen von dem genannten Elektronendonator, durch das genannte Donatorglied, die genannte Regelungsverbindung für das elektrische Feld, durch das genannte Akzeptorglied, durch den genannten Elektronenakzeptor und zurück zum Elektronendonator fließen.

29. Verfahren nach Anspruch 27 oder 28, wobei das genannte leitfähige Medium eine wässrige Lösung aufweist.

30. Verfahren zum Ändern der Leitfähigkeit eines elektrischen Leiters, wobei:
der elektrische Leiter eine Elektronenquelle aufweist, die elektrisch an einen leitfähigen Metall enthaltenden Nucleinsäureduplex angeschlossen ist, welcher einen ersten Nucleinsäurestrang und einen zweiten Nucleinsäurestrang aufweist, wobei der erste und der zweite Nucleinsäurestrang eine Mehrzahl von Stickstoff enthaltenden aromatischen Basen aufweist, die kovalent durch eine Hauptkette verbunden sind, wobei die Stickstoff enthaltenden aromatischen Basen des ersten Nucleinsäurestranges durch Wasserstoffbindung an die Stickstoff enthaltenden aromatischen Basen des zweiten Nucleinsäurestranges gebunden sind, wobei die Stickstoff enthaltenden aromatischen Basen des ersten und des zweiten Nucleinsäurestranges Wasserstoff gebundene Basenpaare in gestapelter Form längs des leitfähigen Metall enthaltenden Nucleinsäureduplex ausbilden, die Wasserstoff gebundenen Basenpaare ein interchelatierendes divalentes Metallkation aufweisen, das an ein Stickstoffatom in einer der Stickstoff enthaltenden aromatischen Basen koordiniert ist, um einen elektrischen Leiter zu bilden, wobei weiters eine Elektronensenke vorgesehen ist, die elektrisch an den leitfähigen, Metall enthaltenden Nucleinsäureduplex angeschlossen ist, wobei die Elektronenquelle ein Elektronen spendendes Molekül ist, das zur Abgabe eines Elektrons an den leitfähigen, Metall enthaltenden Nucleinsäureduplex imstande ist, und die Elektronensenke ein Elektronen annehmendes Molekül ist, das zum Empfangen eines Elektrons von dem leitfähigen, Metall enthaltenden Nucleinsäureduplex imstande ist;
**dadurch gekennzeichnet, dass** die Leitfähigkeit des elektrischen Leiters durch reversibles chemisches Modifizieren des Elektronendonators oder des Elektronenakzeptors unter Bedingungen geändert wird, welche die Leitfähigkeit des elektrischen Leiters bewahrt.

31. Verfahren nach Anspruch 30, wobei das genannte divalente Metallkation aus der Gruppe bestehend aus Zink, Kobalt und Nickel ausgewählt ist.

32. Verfahren nach Anspruch 30 oder 31, wobei das genannte Elektronen spendende Molekül ein fluoreszierendes Molekül aufweist.

33. Verfahren nach Anspruch 30 oder 31, wobei das genannte Elektronen spendende Molekül Fluorescein aufweist.

34. Verfahren nach einem der Ansprüche 30 bis 33, das genannte Elektronen empfangende Molekül eine fluoreszierendes Molekül aufweist.

35. Verfahren nach einem der Ansprüche 30 bis 33, wobei das genannte Elektronen empfangende Molekül Rhodamin aufweist.

36. Verfahren nach einem der Ansprüche 30 bis 33, wobei das genannte Elektronen empfangende Molekül Anthrachinon aufweist.

37. Verfahren nach Anspruch 36, wobei die Leitfähigkeit des elektrischen Leiters durch reversibles chemisches Reduzieren des Anthrachinons zu Dihydroanthrachinon geändert wird.

## Revendications

1. Procédé pour modifier la conductivité d'un élément de circuit organique (100), dans lequel l'élément de circuit organique comprend :
a) une pluralité de membres (102), comprenant chacun un duplex d'oligonucléotides, ladite pluralité de membres comprenant :
i) au moins un membre donneur (104) pour recevoir des électrons de conduction d'un donneur d'électrons (200) ;
ii) au moins un membre accepteur (106) pour communiquer avec un accepteur d'électrons (220) afin de fournir une région d'attraction pour lesdits électrons de conduction; et
iii) au moins un membre régulateur (108) coupant au moins un membre de ladite pluralité de membres (102) pour définir au moins une jonction de régulation de champ électrique (112) en vue d'une coopération avec un régulateur de champ électrique (114) pour réguler un champ électrique au niveau de la jonction (112);
**caractérisé en ce que** la conductivité de l'élément de circuit organique (100) est modifiée en transformant chimiquement, de façon réversible, le donneur d'électrons (200) ou l'accepteur d'électrons (220) dans des conditions qui préservent la conductivité de l'élément de circuit organique (100).

2. Procédé selon la revendication 1, dans lequel au moins l'un desdits membres (102) comprend un duplex d'oligonucléotides conducteur contenant un métal.

3. Procédé selon la revendication 1 ou 2, dans lequel ledit donneur d'électrons (200) est en communication électrique avec ledit membre donneur (104).

4. Procédé selon la revendication 3, dans lequel ledit accepteur d'électrons (220) est en communication électrique avec ledit membre accepteur (106).

5. Procédé selon la revendication 4, dans lequel ledit régulateur de champ électrique (114) est en communication électrique avec ledit membre régulateur (108).

6. Procédé selon l'une quelconque des revendications 1 à 5, dans lequel ledit membre donneur (104), ledit membre accepteur (106) et ledit membre régulateur (108) se coupent pour définir ladite jonction de régulation de champ électrique (112).

7. Procédé selon l'une quelconque des revendications 1 à 5 dans lequel ledit membre régulateur (108) coupe l'un desdits membres donneur (104) et desdits membres accepteur (106) pour définir ladite jonction de régulation de champ électrique (112).

8. Procédé selon l'une quelconque des revendications 1 à 7, dans lequel ledit duplex d'oligonucléotides conducteur contenant un métal comprend un premier brin d'acide nucléique (320) et un second brin d'acide nucléique (340), lesdits premier et second brins d'acide nucléique comprenant des pluralités respectives de bases aromatiques contenant de l'azote (350, 360) reliées par covalence à une ossature (380), lesdites bases aromatiques contenant de l'azote dudit premier brin d'acide nucléique étant réunies par liaison hydrogène auxdites bases aromatiques contenant de l'azote dudit second brin d'acide nucléique, lesdites bases aromatiques contenant de l'azote sur lesdits premier et second brins d'acide nucléique formant des paires de bases à liaison hydrogène (400) selon un aménagement d'empilement tout le long dudit duplex d'oligonucléotides conducteur contenant un métal (300), lesdites paires de bases à liaison hydrogène comprenant un cation métallique interchélaté (420) en coordination avec un atome d'azote situé dans l'une desdites bases aromatiques contenant de l'azote (350, 360).

9. Procédé selon la revendication 8, dans lequel ledit cation métallique interchélaté comprend un cation métallique divalent interchélaté.

10. Procédé selon la revendication 9, dans lequel ledit cation métallique divalent est choisi dans le groupe constitué du zinc, du cobalt et du nickel.

11. Procédé selon la revendication 8, 9 ou 10, dans lequel lesdits premier et second brins d'acide nucléique comprennent de l'acide désoxyribonucléique et lesdites bases aromatiques contenant de l'azote sont choisies dans le groupe constitué de l'adénine, de la thymine, de la guanine et de la cytosine.

12. Procédé selon l'une quelconque des revendications 1 à 11, dans lequel ledit donneur d'électrons comprend une électrode pouvant fonctionner pour céder un électron audit membre donneur.

13. Procédé selon l'une quelconque des revendications 1 à 12, dans lequel ledit accepteur d'électrons comprend une électrode pouvant fonctionner pour accepter un électron dudit membre accepteur.

14. Procédé selon l'une quelconque des revendications 1 à 11, dans lequel ledit donneur d'électrons comprend une molécule donneur d'électrons capable de céder un électron audit membre donneur.

15. Procédé selon la revendication 14, dans lequel ladite molécule donneur d'électrons comprend une molécule fluorescente.

16. Procédé selon la revendication 14, dans lequel ladite molécule donneur d'électrons comprend la fluorescéine.

17. Procédé selon l'une quelconque des revendications 1 à 16, dans lequel ledit accepteur d'électrons comprend une molécule accepteur d'électrons capable d'accepter un électron dudit membre accepteur.

18. Procédé selon la revendication 17, dans lequel ladite molécule accepteur d'électrons comprend une molécule fluorescente.

19. Procédé selon la revendication 17, dans lequel ladite molécule accepteur d'électrons comprend la rhodamine.

20. Procédé selon la revendication 17, dans lequel ladite molécule accepteur d'électrons comprend l'anthraquinone.

21. Procédé selon la revendication 20, dans lequel la conductivité de l'élément de circuit organique est modifiée en réduisant chimiquement et de manière réversible l'anthraquinone en dihydroanthraquinone.

22. Procédé selon l'une quelconque des revendications 1 à 21, dans lequel ledit régulateur de champ électrique comprend un chromophore régulateur.

23. Procédé selon l'une quelconque des revendications 1 à 21, dans lequel ledit régulateur de champ électrique comprend une rhodamine.

24. Procédé selon l'une quelconque des revendications 1 à 21, dans lequel ledit régulateur de champ électrique comprend une électrode.

25. Procédé selon l'une quelconque des revendications 1 à 24, dans lequel ledit régulateur de champ électrique comprend une pluralité d'états, chaque état de ladite pluralité d'états pouvant être choisi de manière à produire un potentiel électrostatique respectif au niveau de ladite jonction de régulation de champ électrique.

26. Procédé selon la revendication 25, dans lequel lesdits états peuvent être choisis en réponse à un potentiel externe appliqué.

27. Procédé selon l'une quelconque des revendications 1 à 26, dans lequel l'élément de circuit organique est ménagé dans un milieu conducteur qui délivre des électrons de conduction audit donneur d'électrons et qui reçoit des électrons de conduction dudit accepteur d'électrons.

28. Procédé selon la revendication 27, dans lequel ledit milieu conducteur peut fonctionner pour céder des électrons audit donneur d'électrons, et peut fonctionner pour accepter des électrons dudit accepteur d'électrons, afin de générer un circuit fermé permettant la circulation des électrons dudit donneur d'électrons via ledit membre donneur, via ladite jonction de régulation de champ électrique, via ledit membre accepteur, via ledit accepteur d'électrons, pour revenir ainsi audit donneur d'électrons.

29. Procédé selon la revendication 27 ou 28, dans lequel ledit milieu conducteur comprend une solution aqueuse.

30. Procédé pour modifier la conductivité d'un conducteur électrique, dans lequel :
le conducteur électrique comprend une source d'électrons couplée électriquement à un duplex d'acides nucléiques conducteur contenant un métal, le duplex d'acides nucléiques conducteur contenant un métal comprenant un premier brin d'acide nucléique et un second brin d'acide nucléique, les premier et second brins d'acide nucléique comprenant une pluralité de bases aromatiques contenant de l'azote reliées par covalence à une ossature, les bases aromatiques contenant de l'azote du premier brin d'acide nucléique étant réunies par une liaison hydrogène aux bases aromatiques contenant de l'azote du second brin d'acide nucléique, les bases aromatiques contenant de l'azote des premier et second brins d'acide nucléique formant des paires de bases à liaison hydrogène aménagées selon un empilement tout le long du duplex d'acides nucléiques conducteur contenant un métal, les paires de bases à liaison hydrogène comprenant un cation métallique divalent interchelaté, en coordination avec un atome d'azote situé dans l'une des bases aromatiques contenant de l'azote, pour former le conducteur électrique, comprenant en outre un puit à électrons couplé électriquement au duplex d'acides nucléiques conducteur contenant un métal, dans lequel la source d'électrons est une molécule donneur d'électrons capable de céder un électron au duplex d'acides nucléiques conducteur contenant un métal et le puit à électrons est une molécule accepteur d'électrons capable d'accepter un électron du duplex d'acides nucléiques conducteur contenant un métal;
**caractérisé en ce que** la conductivité du conducteur électrique est modifiée en transformant chimiquement et de manière réversible le donneur d'électrons ou l'accepteur d'électrons dans des conditions qui préservent la conductivité du conducteur électrique.

31. Procédé selon la revendication. 30, dans lequel ledit cation métallique divalent est choisi dans le groupe constitué du zinc, du cobalt et du nickel.

32. Procédé selon la revendication 30 ou 31, dans lequel ladite molécule donneur d'électrons comprend une molécule fluorescente.

33. Procédé selon la revendication 30 ou 31, dans lequel ladite molécule donneur d'électrons comprend la fluorescéine.

34. Procédé selon l'une quelconque des revendications 30 à 33, dans lequel ladite molécule accepteur d'électrons comprend une molécule fluorescente.

35. Procédé selon l'une quelconque des revendications 30 à 33, dans lequel ladite molécule accepteur d'électrons comprend la rhodamine.

36. Procédé selon l'une quelconque des revendications 30 à 33, dans lequel ladite molécule accepteur d'électrons comprend l'anthraquinone.

37. Procédé selon la revendication 36, dans lequel la conductivité du conducteur électrique est modifiée en réduisant chimiquement et de manière réversible l'anthraquinone en dihydroanthraquinone.
